(19) Europäisches Patentamt / European Patent Office / Office européen des brevets

(11) **EP 2 952 471 B1**

(12) **FASCICULE DE BREVET EUROPEEN**

(45) Date de publication et mention de la délivrance du brevet:
**19.09.2018 Bulletin 2018/38**

(21) Numéro de dépôt: **15170144.8**

(22) Date de dépôt: **01.06.2015**

(51) Int Cl.:
**B81C 1/00** *(2006.01)*     **B81B 7/02** *(2006.01)*

(54) **STRUCTURE D'ENCAPSULATION A PLUSIEURS CAVITES MUNIES DE CANAUX D'ACCES DE HAUTEURS DIFFERENTES**

VERKAPSELUNGSSTRUKTUR MIT MEHREREN HOHLRÄUMEN VERSEHEN MIT ZUGANGSKANÄLEN UNTERSCHIEDLICHER HÖHE

ENCAPSULATION STRUCTURE COMPRISING SEVERAL CAVITIES HAVING VENTS OF DIFFERING HEIGHTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.06.2014 FR 1455019**

(43) Date de publication de la demande:
**09.12.2015 Bulletin 2015/50**

(73) Titulaire: **Commissariat à l'Énergie Atomique et aux Énergies Alternatives 75015 Paris (FR)**

(72) Inventeur: **Baillin, Xavier 38920 Crolles (FR)**

(74) Mandataire: **Brevalex 95, rue d'Amsterdam 75378 Paris Cedex 8 (FR)**

(56) Documents cités:
**US-A1- 2008 211 076**    **US-A1- 2008 308 919**
**US-A1- 2013 265 701**    **US-A1- 2014 008 738**

**Description**

**DOMAINE TECHNIQUE ET ART ANTÉRIEUR**

L'invention concerne le domaine des structures d'encapsulation comportant plusieurs cavités avantageusement destinées à comporter des atmosphères différentes, et dans lesquelles différents micro-dispositifs, par exemple de type MEMS, NEMS, MOEMS, NOEMS, ou des détecteurs infrarouges de type micro-bolomètre, sont avantageusement destinés à être encapsulés de façon hermétique.

Certains micro-dispositifs nécessitent pour leur bon fonctionnement d'être enfermés dans une cavité dont l'atmosphère (en termes de nature des gaz et de pression) est contrôlée. Pour cela, il est possible de réaliser ces micro-dispositifs collectivement sur des tranches, ou wafers ou substrats, de silicium puis de les encapsuler dans des cavités via un report d'un capot correspondant généralement à un autre substrat en silicium ou en verre (assemblage « Wafer to Wafer », également appelé assemblage W2W), ou via une encapsulation par une ou plusieurs couches minces superposées et déposées sur une couche sacrificielle qui, après destruction, forme des volumes libres entre le substrat et les couches minces formant les cavités (encapsulation « Thin Film Packaging », également appelée TFP, ou PCM pour « Packaging Couche Mince »). Les cavités hermétiques ainsi définies permettent de préserver les atmosphères qui entourent les micro-dispositifs dans les cavités vis-à-vis de l'atmosphère extérieure.

L'ajout d'un getter en couche mince, préalablement déposé sur le ou l'un des substrats avant la réalisation d'une cavité, permet de contrôler l'atmosphère dans la cavité. Ainsi, la réalisation d'une cavité incluant un micro-dispositif sous atmosphère contrôlée inclut généralement le dépôt d'un getter sur l'un ou l'autre des deux substrats au préalable à l'opération d'assemblage pour la technologie W2W ou, dans le cas d'une technologie TFP, le dépôt du getter soit au premier niveau sur le substrat d'accueil du micro-dispositif soit directement sous la forme d'une première couche d'encapsulation. Il est possible d'obtenir par cette technique une pression résiduelle minimale de gaz dans la cavité, par exemple comprise entre environ $10^{-3}$ et $10^{-4}$ mbar. L'ajout d'un gaz rare (argon par exemple) lors de l'opération de fermeture de la cavité et en présence d'un getter permet de contrôler des pressions résiduelles supérieures à ces valeurs.

Certains micro-dispositifs, par exemple les micro-dispositifs inertiels à six degrés de liberté, incluant notamment un accéléromètre et un gyromètre dans une même puce, nécessitent un procédé de packaging spécifique puisque chacun des micro-dispositifs est encapsulé dans une cavité hermétique distincte sous atmosphère contrôlée du fait que les deux micro-dispositifs fonctionnent à des pressions différentes. Pour fermer hermétiquement au moins deux cavités sous des atmosphères différentes, il existe plusieurs solutions qui s'appliquent généralement pour une encapsulation de type W2W et, dans certains cas, à une encapsulation de type TFP.

Le document US 8 590 376 B2 décrit un dispositif comportant deux capteurs encapsulés chacun dans une cavité distincte, les cavités étant obtenues par une encapsulation de type W2W. La nature des gaz et/ou la pression au sein des cavités sont contrôlées individuellement dans chaque cavité en disposant un getter dans l'une des cavités et en ne disposant pas de getter dans l'autre cavité, ou en disposant dans les cavités des getters présentant des propriétés d'absorption différentes.

Du fait que le scellement des cavités est réalisé lors de l'assemblage des deux wafers, il est difficile de maîtriser la qualité de l'atmosphère résiduelle (nature des gaz et pression). En effet, celle-ci est liée aux procédés technologiques préalables à l'assemblage qui génèrent des adsorptions gazeuses notamment sur les parois des cavités. Des problèmes de reproductibilité se posent donc dans ce cas. Cette solution permet donc d'obtenir des pressions comprises entre environ $10^{-4}$ mbar et quelques mbar d'une atmosphère non contrôlée.

Le document US 8 350 346 B1 propose de créer des cavités de volumes différents. Ainsi, pour une même pression de fermeture, les pressions résiduelles vont dépendre directement du rapport des volumes des cavités car le rapport surface/volume décroît quand la cavité est plus profonde, conférant ainsi une pression plus faible pour la cavité de plus grande profondeur. Toutefois, la variation de volume possible entre les cavités étant limitée, les différences de pression pouvant être obtenues au sein des cavités sont également limitées (différence d'un facteur 2 ou 3 maximum). De plus, un processus de dégazage se produit lors de la fermeture des cavités, qui repose sur les espèces adsorbées au niveau des surfaces des cavités, ce qui pose des problèmes de reproductibilité.

Les documents US 8 035 209 B2 et US 2014/0008738 A1 proposent de fermer deux cavités lors d'une même opération, puis d'ouvrir au moins une des deux cavités pour la refermer ensuite sous une pression différente via un dépôt d'un film mince. Il est également décrit la possibilité de réaliser, à travers une première couche d'encapsulation, des trous d'accès aux deux cavités, les dimensions des trous étant différentes pour les deux cavités. Ainsi, un premier dépôt d'un film mince permet d'obstruer les trous de plus petites dimensions et fermer hermétiquement la cavité associée à ces trous, alors qu'un second dépôt permet ensuite de fermer hermétiquement l'autre cavité.

Toutefois, ce procédé nécessite la mise en oeuvre de nombreuses étapes par rapport aux autres procédés. De plus, il existe un risque de pollution de l'intérieur des cavités, notamment au niveau de celle comportant les trous de plus grandes dimensions lors du dépôt de la première couche d'encapsulation. Enfin, lorsque ce procédé est appliqué pour une encapsulation de type TFP, il présente l'inconvénient de créer aussi un dépôt dans les cavités qui peut être gênant pour le bon fonctionnement du dispositif ou qui nécessite une conception appropriée pour éviter cet inconvénient.

Le document US 2012/0326248 A1 décrit quatre solutions pour réaliser plusieurs cavités comportant des atmosphères différentes.

La première solution repose sur la création d'une première cavité avant la création d'une seconde cavité lors de l'étape d'assemblage. La première cavité est bouchée en utilisant des procédés de dépôt sur une cavité préexistante.

La deuxième solution s'appuie sur le contrôle des cycles d'assemblage entre les wafers, et propose trois technologies. La première technologie met en jeu des cordons de scellement de températures de fusion différentes. Ainsi, lors d'une première fusion il est possible de fermer un premier ensemble de cavités sous une atmosphère donnée, puis en augmentant la température de fermer un second ensemble de cavités sous une autre atmosphère. La seconde technologie repose sur l'utilisation d'un même matériau de scellement, mais des dessins de cordons différents. Pour les premières cavités, les cordons sont continus, alors que pour les secondes cavités, les cordons possèdent une ouverture qui permet de créer une fuite entre l'intérieur de la cavité et la chambre de scellement. Il est ainsi possible de fermer les premières cavités sous une atmosphère donnée, puis de changer l'atmosphère et d'appuyer plus sur l'assemblage de façon à fermer les secondes cavités. La troisième technologie utilise un matériau dégazeur ou getter, qui est introduit dans au moins une cavité au préalable à l'assemblage. Il s'active soit comme dégazeur, soit comme getter sous l'action de la température. Les difficultés essentielles de cette technologie sont toutefois la maîtrise de la pression finale ainsi que la reproductibilité, du fait qu'il est difficile de bien contrôler la teneur en gaz dans le matériau dégazeur. La quatrième technologie met en jeu des cordons de scellement de hauteurs différentes sur l'un des deux wafers à assembler. Ils sont par exemple plus épais sur le pourtour des premières cavités, comparativement aux secondes cavités. Il est ainsi possible de fermer les premières cavités sous une première atmosphère, puis les secondes sous une autre atmosphère.

La troisième solution met en oeuvre la création de réservoir dans les pré-cavités usinées dans le premier substrat. Ces pré-cavités, en dehors de la zone du réservoir, sont en communication avec l'atmosphère ambiante. Les cavités finales sont formées sur les pré-cavités lors de l'assemblage entre les substrats. L'ouverture du réservoir permet alors de remplir la cavité avec le gaz du réservoir.

La quatrième solution utilise la création post-assemblage d'un canal débouchant soit sur l'une des cavités soit à proximité de celle-ci, alors que les autres cavités ont été fermées lors de l'assemblage. Dans ce cas de figure, le canal débouche sur une couche d'oxyde de silicium qui se situe sur la périphérie de la cavité et dont la résistance à la perméation des gaz est connue. Il est ainsi possible de contrôler le remplissage de cette cavité par une atmosphère donnée, puis de boucher le canal avec un dépôt approprié.

Toutes ces solutions nécessitent soit de nombreuses étapes technologiques, soit utilisent, au moins dans une cavité, une pression résiduelle issue directement du cycle d'assemblage, posant ainsi des problèmes de reproductibilité.

Le document US 2014/0038364 A1 propose de créer des fenêtres de diffusion de sections différentes dans le capot (notamment pour un capot verre, perméable à l'hélium, les fenêtres de diffusion sont définies par un masque métallique, imperméable à la diffusion de l'hélium, déposé sur le capot). Ces fenêtres sont définies une fois les cavités hermétiques scellées et le gaz est introduit dans les cavités en exposant le composant à une pression contrôlée de gaz, pendant un temps et une température définis. Une fois les cavités remplies à la pression voulue, un film hermétique est déposé en vue de fermer les fenêtres.

Cette solution implique toutefois de maîtriser l'atmosphère résiduelle dans les cavités après assemblage des substrats. Il est donc possible de rencontrer des problèmes d'uniformité sur un même wafer et de reproductibilité d'un wafer à l'autre. De plus, cette technique ne s'applique que pour un capot perméable à certains gaz, ce qui limite le choix de la nature du capot et des gaz.

## EXPOSÉ DE L'INVENTION

Un but de la présente invention est de proposer une structuration d'encapsulation comportant plusieurs cavités dans lesquelles des atmosphères différentes (en termes de nature des gaz et de pression) peuvent être obtenues et ne présentant pas les inconvénients des structures de l'art antérieur précédemment décrites.

Pour cela, la présente invention propose une structure d'encapsulation comportant :

- au moins un capot solidarisé à au moins un premier substrat et formant au moins des première et deuxième cavités distinctes entre le capot et le premier substrat,
- au moins des premier et deuxième canaux formés dans le premier substrat et/ou dans le capot et/ou entre le premier substrat et le capot, tels que le premier canal comporte une première extrémité débouchant dans la première cavité et une deuxième extrémité débouchant hors de la première cavité par l'intermédiaire d'au moins un premier trou formé à travers le capot, et que le deuxième canal comporte une première extrémité débouchant dans la deuxième cavité et une deuxième extrémité débouchant hors de la deuxième cavité par l'intermédiaire d'au moins un deuxième trou formé à travers le capot,

dans laquelle une hauteur $H_A$ du premier canal au niveau de sa deuxième extrémité est inférieure à une hauteur $H_B$ du deuxième canal au niveau de sa deuxième extrémité,

et dans laquelle au moins une première couche de fermeture d'épaisseur $E_1$ supérieure à la hauteur $H_A$ et inférieure à la hauteur $H_B$ ferme le premier canal sans fermer le deuxième canal, et dans laquelle le deuxième canal est fermé, les atmosphères dans les première et deuxième cavités étant différentes en terme de pression et/ou de nature de gaz.

Chaque cavité est munie d'au moins un canal mettant en communication l'intérieur de la cavité avec l'extérieur de celle-ci. Du fait que la hauteur $H_A$ du premier canal est inférieure à celle (hauteur $H_B$) du deuxième canal, ce premier canal peut donc être fermé avant le deuxième canal par exemple par le dépôt d'une première couche de fermeture dont l'épaisseur est supérieure à la hauteur $H_A$ et inférieure à la hauteur $H_B$, fermant ainsi uniquement la première cavité à l'atmosphère souhaitée sans fermer la deuxième cavité. La deuxième cavité peut être ensuite fermée avec une autre atmosphère indépendamment de celle dans la première cavité.

La structure d'encapsulation selon l'invention présente les avantages suivants :

- elle permet de réaliser plusieurs cavités fermées avec des atmosphères contrôlées dans chacune d'elles et indépendantes les unes des autres ;
- les gammes de pressions pouvant être obtenues dans les cavités sont étendues, et peuvent par exemple aller jusqu'à environ $10^{-6}$ mbar ;
- pas de limitation concernant les écarts possibles entre les pressions avec lesquelles les cavités peuvent être fermées ;
- bonne reproductibilité des atmosphères avec lesquelles les cavités peuvent être fermées ;
- nombre d'étapes réduit pour réaliser la fermeture des cavités ;
- pas ou peu de risque de pollution à l'intérieur des cavités, notamment par les matériaux utilisés pour fermer les cavités ;
- pas de limitation sur la nature des gaz pouvant être enfermés dans les cavités.

La hauteur, ou épaisseur, d'un canal peut correspondre à une dimension dudit canal qui est sensiblement perpendiculaire à une direction principale selon laquelle s'étend ledit canal (par exemple, dans le cas d'un canal rectiligne, le canal s'étend selon une direction principale allant de la première extrémité à la deuxième extrémité du canal). La hauteur peut par exemple correspondre à une dimension du canal qui est sensiblement perpendiculaire à une face principale du premier substrat, par exemple la face du premier substrat sur laquelle se trouve le capot. La hauteur peut par exemple correspondre à une dimension du canal qui est sensiblement perpendiculaire à une face principale du capot, notamment dans le cas d'un canal formé dans le capot, et/ou à une face principale du premier substrat.

La hauteur $H_A$ du premier canal peut être sensiblement constante sur toute la longueur du premier canal, c'est-à-dire entre sa première extrémité et sa deuxième extrémité. La hauteur $H_B$ du deuxième canal peut être sensiblement constante sur toute la longueur du deuxième canal.

La différence entre les hauteurs $H_A$ et $H_B$ peut être telle qu'il est possible de fermer le premier canal via le dépôt d'une couche de fermeture au niveau des deuxièmes extrémités des premier et deuxième canaux sans fermer le deuxième canal. Une telle différence de hauteurs entre les canaux ne correspond pas à une différence de hauteurs engendrée par des imprécisions dues à la réalisation des canaux.

Le premier trou peut comporter, au niveau d'une face avant du capot (face opposée à celle se trouvant en regard ou contre le premier substrat), une section appartenant à un plan sensiblement perpendiculaire à la hauteur du premier canal. De même, le deuxième trou peut comporter, au niveau de la face avant du capot, une section appartenant à un plan sensiblement perpendiculaire à la hauteur du deuxième canal.

Les premier et deuxième canaux peuvent former des évents latéraux (c'est-à-dire débouchant sur le côté des cavités) présentant des hauteurs différentes.

La structure d'encapsulation selon l'invention peut être avantageusement utilisée pour réaliser une encapsulation collective de plusieurs micro-dispositifs destinés à fonctionner sous des atmosphères différentes, c'est-à-dire à des pressions différentes et/ou dans des environnements gazeux différents.

Les canaux peuvent être réalisés au niveau des bords des cavités, notamment lorsque les canaux sont formés dans le premier substrat et/ou entre le premier substrat et le capot, et peuvent donc ne pas être disposés à l'aplomb de micro-dispositifs disposés dans les cavités, ce qui évite de les polluer ou de les endommager lors des fermetures des cavités.

La deuxième extrémité du premier canal peut être bouchée par au moins une première portion d'une première couche de fermeture d'épaisseur $E_1$ supérieure à la hauteur $H_A$ et inférieure à la hauteur $H_B$, et la deuxième extrémité du deuxième canal peut être bouchée par au moins :

- une deuxième portion de la première couche de fermeture et une portion d'une deuxième couche de fermeture d'épaisseur $E_2$ telle que $H_B < (E_1 + E_2)$, ou
- la deuxième portion de la première couche de fermeture et une portion de matériau brasée sur la deuxième portion de la première couche de fermeture et d'épaisseur $E_2$ telle que $H_B < (E_1 + E_2)$, ou
- la deuxième portion de la première couche de fermeture et une portion de couche de bouchage bouchant le deuxième trou sur le capot.

La première et la deuxième couches de fermeture peuvent être, indépendamment l'une de l'autre, monocouche ou multicouche. De même, la couche de bouchage peut être monocouche ou multicouche, et déposée sur tout ou partie du capot de sorte qu'au moins une portion de cette couche de bouchage obture le deuxième trou formé à travers le capot.

Au moins un premier micro-dispositif peut être disposé dans la première cavité et/ou au moins un deuxième micro-dispositif peut être disposé dans la deuxième cavité. Le premier et/ou le deuxième micro-dispositif peuvent être de type MEMS, NEMS, MOEMS, NOEMS, ou des détecteurs infrarouges de type microbolomètre.

La structure d'encapsulation peut être telle que :

- lorsque le premier micro-dispositif est disposé dans la première cavité, la première couche de fermeture comporte au moins un matériau électriquement conducteur, la structure d'encapsulation comportant au moins un premier élément de connexion électrique relié au premier micro-dispositif et à la première portion de la première couche de fermeture, et au moins un premier contact électrique disposé au moins en partie dans le premier trou et relié à la première portion de la première couche de fermeture, et/ou

- lorsque le deuxième micro-dispositif est disposé dans la deuxième cavité, les matériaux bouchant la deuxième extrémité du deuxième canal sont électriquement conducteurs, la structure d'encapsulation comportant au moins un deuxième élément de connexion électrique relié au deuxième micro-dispositif et à la deuxième portion de la première couche de fermeture, et au moins un deuxième contact électrique disposé au moins en partie dans le deuxième trou et relié à la portion de la deuxième couche de fermeture ou à la portion de matériau brasée sur la deuxième portion de la première couche de fermeture.

Ainsi, au moins l'un des micro-dispositifs peut être accessible électriquement depuis la face avant de la structure d'encapsulation via le premier et/ou le deuxième contact électrique. Le premier et/ou le deuxième contact électrique peuvent notamment s'étendre le long du premier et/ou du deuxième trou et également sur le capot.

Le premier canal peut traverser au moins une paroi latérale de la première cavité et/ou le deuxième canal peut traverser au moins une paroi latérale de la deuxième cavité.

Le capot peut comporter au moins un substrat appelé deuxième substrat et solidarisé au premier substrat et tel que les première et deuxième cavités sont formées au moins en partie dans le deuxième substrat. Une telle structure d'encapsulation peut être réalisée par un procédé de type W2W. Le premier et/ou le deuxième canal peuvent être formés dans le deuxième substrat.

Dans ce cas, le deuxième substrat peut être solidarisé au premier substrat par l'intermédiaire d'une interface de collage disposée entre le premier substrat et le deuxième substrat et telle que les premier et deuxième canaux sont formés au moins en partie dans l'interface de collage. Dans cette configuration, il est également possible que les canaux soient formés dans l'interface de collage ainsi que dans le premier substrat et/ou dans le deuxième substrat.

Le capot peut comporter au moins une couche mince disposée sur le premier substrat, et les premier et deuxième canaux peuvent être formés au moins dans le premier substrat. Une telle structure d'encapsulation peut être réalisée par un procédé de type TFP. Le terme « couche mince » désigne ici une couche de matériau dont l'épaisseur est inférieure ou égale à environ 20 μm.

Le capot peut comporter au moins deux couches minces superposées l'une au-dessus de l'autre et disposées sur le premier substrat, et les premier et deuxième canaux peuvent être formés au moins par des espaces entre les deux couches minces. Une telle structure d'encapsulation peut être réalisée par un procédé de type TFP.

L'invention concerne également un procédé de réalisation d'une structure d'encapsulation, comportant au moins les étapes suivantes :

- réalisation d'au moins un capot solidarisé à au moins un premier substrat formant au moins des première et deuxième cavités distinctes entre le capot et le premier substrat,
- réalisation d'au moins des premier et deuxième canaux dans le premier substrat et/ou dans le capot et/ou entre le premier substrat et le capot, tels que le premier canal comporte une première extrémité débouchant dans la première cavité et une deuxième extrémité débouchant hors de la première cavité par l'intermédiaire d'au moins un premier trou formé à travers le capot, et que le deuxième canal comporte une première extrémité débouchant dans la deuxième cavité et une deuxième extrémité débouchant hors de la deuxième cavité par l'intermédiaire d'au moins un deuxième trou formé à travers le capot, dans lequel une hauteur $H_A$ du premier canal au niveau de sa deuxième extrémité est inférieure à une hauteur $H_B$ du deuxième canal au niveau de sa deuxième extrémité
- dépôt d'au moins une première couche de fermeture d'épaisseur $E_1$ supérieure à la hauteur $H_A$ et inférieure à la hauteur $H_B$, fermant le premier canal sans fermer le deuxième canal, puis
- fermeture du deuxième canal,

les atmosphères dans les première et deuxième cavités étant différentes en terme de pression et/ou de nature de gaz.

Le procédé peut comporter en outre, après la réalisation du capot et des premier et deuxième canaux, un dépôt d'au moins une première couche de fermeture d'épaisseur $E_1$ supérieure à la hauteur $H_A$ et inférieure à la hauteur $H_B$ telle qu'au moins une première portion de la première couche de fermeture bouche la deuxième extrémité du premier canal, puis :

- un dépôt d'au moins une deuxième couche de fermeture d'épaisseur $E_2$ telle que $H_B < (E_1 + E_2)$ et qu'au moins une deuxième portion de la première couche de fermeture et une portion de la deuxième couche de fermeture bouche la deuxième extrémité du deuxième canal, ou
- un dépôt d'au moins une portion de matériau de brasage d'épaisseur $E_2$ telle que $H_B < (E_1 + E_2)$ sur la deuxième portion de la première couche de fermeture, puis un brasage de la portion de matériau de brasage, ou
- la réalisation d'au moins une portion de couche de bouchage bouchant le deuxième trou sur le capot.

La réalisation du capot et des premier et deuxième canaux peut comporter au moins la mise en oeuvre des étapes suivantes :

- réalisation des premier et deuxième canaux au niveau d'une face d'un deuxième substrat destiné à être solidarisé au premier substrat ;
- réalisation des première et deuxième cavités au niveau de ladite face du deuxième substrat ;
- solidarisation de ladite face du deuxième substrat au premier substrat ;
- réalisation des premier et deuxième trous à travers le deuxième substrat,

dans lequel le premier canal peut traverser au moins une paroi latérale de la première cavité et/ou dans lequel le deuxième canal peut traverser au moins une paroi latérale de la deuxième cavité.

Il est possible de réaliser les trous, débouchant ou non, juste après les canaux. Ainsi, les trous, les canaux et les cavités peuvent être pré-usinés dans le capot pour une encapsulation de type W2W préalablement à la solidarisation des substrats entre eux, ce qui permet d'éviter toute opération technologique par voie humide pour réaliser ces éléments post-solidarisation.

En variante, la réalisation du capot et des premier et deuxième canaux peut comporter au moins la mise en oeuvre des étapes suivantes :

- réalisation des première et deuxième cavités au niveau d'une face d'un deuxième substrat destiné à être solidarisé au premier substrat ;
- réalisation d'une interface de collage sur ladite face du deuxième substrat et/ou sur une face du premier substrat à laquelle le deuxième substrat est destiné à être solidarisé, les premier et deuxième canaux étant formés au moins en partie dans l'interface de collage ;

- solidarisation de ladite face du deuxième substrat au premier substrat par l'intermédiaire de l'interface de collage ;
- réalisation des premier et deuxième trous à travers le deuxième substrat.

Là encore, les trous peuvent être réalisés juste après les canaux. Ainsi, les trous, les canaux et les cavités peuvent être réalisés préalablement à la solidarisation des substrats entre eux, ce qui permet d'éviter toute opération technologique par voie humide pour réaliser ces éléments post-solidarisation.

Selon une autre variante, la réalisation du capot et des premier et deuxième canaux peut comporter au moins la mise en oeuvre des étapes suivantes :

- réalisation des premier et deuxième canaux dans le premier substrat ;
- réalisation de première et deuxième portions de matériau sacrificiel sur le premier substrat, dont des volumes correspondent à ceux des première et deuxième cavités et telles que la première portion de matériau sacrificiel recouvre au moins une partie du premier canal et que la deuxième portion de matériau sacrificiel recouvre au moins une partie du deuxième canal ;
- dépôt d'au moins une couche mince sur les première et deuxième portions de matériau sacrificiel ;
- réalisation des premier et deuxième trous à travers la couche mince ;
- gravure des première et deuxième portions de matériau sacrificiel à travers les premier et deuxième trous.

Dans ce cas, les canaux sont réalisés dans le premier substrat préalablement à la réalisation du capot par un procédé de type TFP. Cela permet notamment d'éviter une opération technologique par voie humide lorsque les cavités sont ouvertes.

Selon une autre variante, la réalisation du capot et des premier et deuxième canaux peut comporter au moins la mise en oeuvre des étapes suivantes :

- réalisation de première et deuxième portions de matériau sacrificiel sur le premier substrat, dont des volumes correspondent à ceux des première et deuxième cavités ;
- dépôt d'au moins une première couche mince sur les première et deuxième portions de matériau sacrificiel ;
- réalisation de troisième et quatrième trous à travers la première couche mince, le troisième trou étant formé au niveau d'un emplacement de la première extrémité du premier canal destiné à être réalisé et le quatrième trou étant formé au niveau d'un emplacement de la première extrémité du deuxième canal destiné à être réalisé ;

- réalisation, sur la première couche mince, d'au moins une troisième portion de matériau sacrificiel dont une épaisseur est égale à la hauteur $H_A$, au moins au niveau d'un emplacement du premier canal, et d'au moins une quatrième portion de matériau sacrificiel dont une épaisseur est égale à la hauteur $H_B$, au niveau d'un emplacement du deuxième canal ;
- dépôt d'au moins une deuxième couche mince sur la première couche mince, recouvrant les troisième et quatrième portions de matériau sacrificiel ;
- réalisation des premier et deuxième trous à travers la deuxième couche mince ;
- gravure des première, deuxième, troisième et quatrième portions de matériau sacrificiel à travers au moins les premier et deuxième trous.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1A et 1B représentent schématiquement une structure d'encapsulation, objet de la présente invention, selon un premier mode de réalisation ;
- les figures 2 et 3 représentent schématiquement des étapes de fermeture des cavités de la structure d'encapsulation selon le premier mode de réalisation ;
- les figures 4 à 6 représentent schématiquement la structure d'encapsulation, objet de la présente invention, selon le premier mode de réalisation et dont les cavités sont fermées de différentes façons ;
- les figures 7A et 7B représentent schématiquement une structure d'encapsulation, objet de la présente invention, selon un deuxième mode de réalisation ;
- les figures 8 et 9 représentent schématiquement des étapes de fermeture des cavités de la structure d'encapsulation selon le deuxième mode de réalisation ;
- les figures 10A à 10C représentent schématiquement une structure d'encapsulation, objet de la présente invention, selon une variante du deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

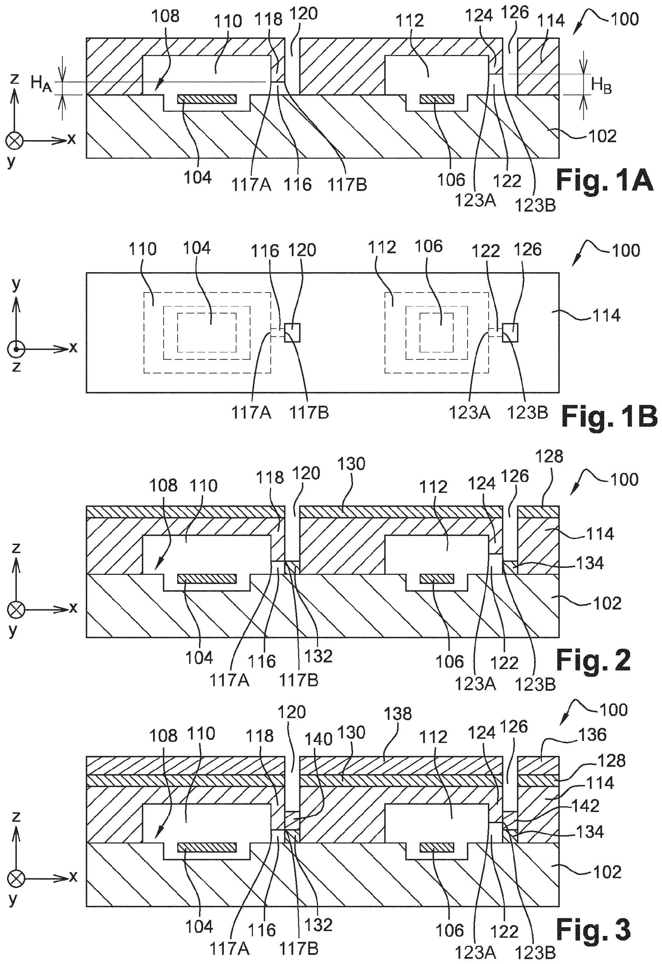

On se réfère tout d'abord aux figures 1A et 1B qui représentent schématiquement une structure d'encapsulation 100 selon un premier mode de réalisation (la figure 1A est une vue en coupe de profil et la figure 1B est une vue de dessus de la structure 100).

La structure 100 comporte un premier substrat 102 comportant par exemple du semi-conducteur tel que du silicium, ou du verre. Deux micro-dispositifs 104 et 106 sont réalisés au niveau d'une face avant 108 du substrat 102. Les micro-dispositifs 104 et 106 sont disposés dans des cavités différentes, à savoir une première cavité 110 pour le premier micro-dispositif 104 et une deuxième cavité 112 pour le deuxième micro-dispositif 106. Les cavités 110 et 112 sont formées dans un capot 114 correspondant à un deuxième substrat, par exemple en semi-conducteur ou en verre, solidarisé au substrat 102 au niveau de sa face avant 108. La structure 100 correspond ici à une structure obtenue par un procédé d'encapsulation de type W2W. Le capot 114 comporte avantageusement un semi-conducteur monocristallin apte à être gravé de façon anisotrope afin de le structurer selon les trois dimensions.

Chacune des cavités 110 et 112 communique avec l'environnement extérieur à la structure 100 par l'intermédiaire d'un canal s'étendant à travers une paroi latérale de la cavité formée dans le capot 114, et d'un trou réalisé à travers le capot 114 et faisant communiquer le canal avec l'extérieur de la structure 100. Sur l'exemple des figures 1A et 1B, un premier canal 116 traverse une paroi latérale 118 de la cavité 110 et débouche dans la cavité 110 au niveau d'un côté de celle-ci, au niveau d'une première extrémité 117A du canal 116. Au niveau d'une deuxième extrémité 117B du canal 116, celui-ci communique avec un premier trou 120 formé à travers toute l'épaisseur du capot 114. De même, un deuxième canal 122 traverse une paroi latérale 124 de la cavité 112 et débouche dans la cavité 112 au niveau d'un côté de celle-ci, au niveau d'une première extrémité 123A du canal 122. Au niveau d'une deuxième extrémité 123B du canal 122, celui-ci communique avec un deuxième trou 126 formé à travers toute l'épaisseur du capot 114. Les trous 120 et 126 ont par exemple, dans un plan perpendiculaire à la direction selon laquelle s'étendent ces trous (ces trous s'étendent selon une direction parallèle à l'axe Z sur les figures 1A et 1B) des sections de forme quelconque (circulaire, polygonale, etc.) et dimensions (par exemple le diamètre dans le cas de trous circulaires) comprises entre environ quelques $\mu$m (moins de 10 $\mu$m) et 100 $\mu$m.

Sur cet exemple, les canaux 116 et 122 sont rectilignes et s'étendent selon une direction sensiblement parallèle à l'axe X représenté, depuis la première extrémité 117A, 123A jusqu'à la deuxième extrémité 117B, 123B, cette direction étant perpendiculaire à la direction selon laquelle les trous s'étendent. Les canaux 116 et 122 s'étendent horizontalement à travers les parois latérales 118 et 124, c'est-à-dire s'étendent selon une direction parallèle à la face du capot 114 solidarisée à la face avant 108 du substrat 102. De plus, les canaux 116 et 122 sont ici réalisés au niveau de l'interface entre le capot 114 et le substrat 102, et sont donc délimités par les parois latérales 118 et 124 ainsi que par la face avant 108 du substrat 102. Sur cet exemple de réalisation, les trous 120 et 126 s'étendent verticalement à travers le capot 114, c'est-à-dire perpendiculairement à la face du capot 114 solidarisée à la face avant 108 du substrat 102 et également perpendiculairement à l'autre face du capot 114 au niveau de laquelle les trous 120 et 126 débouchent (parallèlement à l'axe Z sur les figures 1A et 1B).

Afin de pouvoir fermer successivement les cavités 110 et 112 avec des atmosphères (pression et/ou nature du ou des gaz) différentes, les canaux 116 et 122 sont réalisés de sorte à présenter des hauteurs différentes (la hauteur correspondant à la dimension perpendiculaire à la direction selon laquelle le canal s'étend, c'est-à-dire ici la dimension parallèle à l'axe Z). Sur l'exemple des figures 1A et 1B, le canal 116 est réalisé avec une hauteur $H_A$ qui est choisie comme étant inférieure à une hauteur $H_B$ du canal 122. Avantageusement, la différence entre les hauteurs $H_A$ et $H_B$ est supérieure aux imprécisions liées à leur réalisation, et généralement supérieure à environ 0,1 $\mu$m. Les hauteurs $H_A$ et $H_B$ sont par exemple comprises entre environ 0,1 $\mu$m et 10 $\mu$m. Les canaux 116 et 122 comportent, dans le plan perpendiculaire à leur hauteur (plan parallèle au plan (X,Y)), des dimensions, c'est-à-dire une longueur et une largeur, pouvant varier entre environ 0,5 $\mu$m et plusieurs dizaines de microns voir plusieurs centaines de microns. Chacun des canaux 116, 122 a par exemple, dans le plan (Y,Z), une section de forme rectangulaire ou polygonale.

La figure 2 représente une première étape mise en oeuvre lors d'une fermeture hermétique des cavités 110 et 112. Lors de cette première étape, une première couche de fermeture 128 est déposée, par exemple par un dépôt PVD, sur la structure 100. Des parties 130 de cette couche 128 sont déposées sur le capot 114 et d'autres parties 132, 134 sont déposées dans les trous 120 et 126. Afin que le dépôt de cette couche 128 ferme hermétiquement la cavité 110 mais ne ferme pas la cavité 112, l'épaisseur $E_1$ de la couche 128 est choisie telle que $H_A < E_1 < H_B$. Ainsi, la partie 132 déposée dans le trou 120 a une épaisseur $E_1$ supérieure à la hauteur $H_A$ du canal 116 et bouche hermétiquement le canal 116 au niveau de sa deuxième extrémité 117B se trouvant du côté du trou 120. La partie 134 déposée dans le trou 126 ne bouche pas le canal 122 dont la hauteur $H_B$ est supérieure à l'épaisseur $E_1$. Cette étape de dépôt de la couche 128 est mise en oeuvre sous une atmosphère correspondant à celle souhaitée dans la cavité 110, en termes de nature de gaz et de pression, afin que cette atmosphère se retrouve dans la cavité 110 après le dépôt de la couche 128.

La figure 3 représente une deuxième étape mise en oeuvre lors de la fermeture hermétique des cavités 110 et 112. Lors de cette deuxième étape, une deuxième couche de fermeture 136 est déposée sur la couche 128. Ainsi, des parties 138 de cette couche 136 sont déposées au niveau du capot 114, sur les portions 130 de la couche 128, et d'autres parties 140, 142 sont déposées dans les trous 120 et 126, respectivement sur les parties 132 et 134 de la couche 128. Afin que le dépôt de cette couche 136 réalise la fermeture hermétique de la cavité 112 (la cavité 110 étant déjà fermée hermétiquement par la partie 132 de la couche 128), l'épaisseur $E_2$ de la couche 136 est choisie telle que $H_B < (E_1 + E_2)$. Ainsi, la partie 142 de la couche 136 déposée dans le trou 126 et la partie 134 de la couche 128 bouchent hermétiquement le canal 122, au niveau de sa deuxième extrémité 123B se trouvant du côté du trou 126, dont la hauteur $H_B$ est inférieure à la somme des épaisseurs $E_1$ et $E_2$. Cette étape de dépôt de la couche 136 est mise en oeuvre sous une atmosphère correspondant à celle souhaitée dans la cavité 112, en termes de nature de gaz et de pression, afin que cette atmosphère se retrouve dans la cavité 112 après le dépôt de la couche 136.

Les deux couches 128 et 136 ont par exemple des épaisseurs $E_1$ et $E_2$ chacune comprise entre environ 0,1 $\mu$m et 10 $\mu$m, et comportent par exemple un métal ou tout autre matériau pouvant être déposé selon une pression de gaz contrôlée. Pour fermer hermétiquement au moins l'une des cavités 110, 112 sous vide poussé, la ou les couches 128, 136 sont de préférence déposées par évaporation sous vide secondaire où la pression dans la chambre de dépôt peut être comprise entre environ $10^{-8}$ et $10^{-5}$ mbar. Lorsqu'au moins une des cavités 110, 112 est fermée en contrôlant une pression partielle de gaz neutre tel que de l'argon, la ou les couches 128, 136 peuvent être déposées sur la structure 100 par pulvérisation, ce qui permet de couvrir une gamme de pressions comprises entre environ $10^{-6}$ et $10^{-1}$ mbar avec des épaisseurs de dépôts comprises entre environ 0,1 $\mu$m et 10 $\mu$m.

Préalablement à la mise en oeuvre des étapes de dépôt des couches 128 et 136, la structure 100 est par exemple réalisée par la mise en oeuvre des étapes décrites ci-dessous.

Les micro-dispositifs 104 et 106 sont tout d'abord réalisés dans et/ou sur le substrat 102.

Les canaux 116 et 122 sont ensuite réalisés par photolithographie et gravure du deuxième substrat (par exemple une gravure RIE, ou gravure ionique réactive, lorsque le deuxième substrat comporte du silicium). Les canaux 116 et 122 sont réalisés au niveau de la face du deuxième substrat qui est destinée à être solidarisée au substrat 102.

Les cavités 110 et 112 sont ensuite réalisées par photolithographie et gravure (par exemple une gravure DRIE, ou gravure ionique réactive profonde, dans le cas d'un deuxième substrat en silicium) à travers la même face du deuxième substrat au niveau de laquelle les canaux 116 et 112 ont été réalisés. Les cavités réalisées peuvent avoir une même hauteur, ou profondeur, c'est-à-dire une même dimension depuis ladite face du deuxième substrat jusqu'à la paroi de fond de la cavité. Dans ce cas, si ces cavités sont destinées à avoir des volumes différents, il est possible que les dimensions planaires de ces cavités, c'est-à-dire les dimensions dans le plan de la face du deuxième substrat destinée à être solidarisée au substrat 102, soient différentes. En variante, il est possible d'utiliser plusieurs niveaux de photolithographie et de gravure permettant, à dimensions planaires égales, de moduler la profondeur, ou hauteur, des cavités.

Après la réalisation des canaux 116, 122 et des cavités 110, 112, un dépôt d'une couche diélectrique sur toute la surface du deuxième substrat est avantageusement réalisé, par exemple par la mise en oeuvre d'une oxydation thermique dans le cas d'un deuxième substrat comportant du silicium et formant ainsi une couche de $SiO_2$, par exemple d'épaisseur de l'ordre d'un micron, en surface du deuxième substrat.

Une encapsulation de type W2W est ensuite réalisée en solidarisant le deuxième substrat au substrat 102 par exemple par :

- un scellement métallique par thermocompression et fusion d'un alliage eutectique de brasure disposé entre les deux substrats, l'alliage eutectique étant par exemple de l'AuSn (température de fusion de 280°C), ou de l'AuSi (température de fusion de 363°C), ou de l'AlGe (température de fusion de 419°C) ;

- un scellement direct par collage métallique sans fusion entre des portions de métal formées au préalable sur les substrats (par exemple, collage Cu/Cu, ou Au/Au, ou Ti/Ti, ou W/W) ;

- un scellement direct, ou collage direct (ou collage par adhésion moléculaire), entre les deux substrats en silicium, ou entre l'un des deux substrats en silicium et l'autre en verre ;

- un scellement anodique lorsque l'un des deux substrats est en silicium et que l'autre substrat est en verre.

Avantageusement, le scellement est réalisé sous un vide le plus faible possible (par exemple de quelques $10^{-5}$ mbar) de façon à favoriser le dégazage des cavités au préalable à leur fermeture.

Lorsqu'un matériau de scellement est utilisé, le dépôt de ce matériau de scellement est de préférence réalisé préalablement aux étapes de gravure formant les canaux 116, 112 et les cavités 110, 112 dans le deuxième substrat.

Une fois les deux substrats solidarisés l'un à l'autre, le capot 114 peut être aminci au niveau de sa face arrière (face opposée à celle en contact avec le substrat 102). L'épaisseur restante du capot au niveau de l'interface de collage dépend du rapport de forme (RF) du trou. Il est par exemple possible de déposer du métal en fond de trou de RF proche de 10. Pour un trou de diamètre égal à environ 10 µm, l'épaisseur restante du capot est donc d'environ 100 µm. Pour un trou de diamètre égal à environ 100 µm, il est possible de réduire l'épaisseur du capot pour réduire le temps de gravure.

Les trous 120 et 126 sont ensuite réalisés par photolithographie et gravure, par exemple DRIE, à travers le capot 114 et tels que les trous 120, 126 débouchent au niveau des deuxièmes extrémités 117B, 123B des canaux 116, 122. Si le capot 114 a été préalablement oxydé en surface, la couche d'oxyde formée peut servir de couche d'arrêt de gravure. La gravure de cette couche d'oxyde par voie sèche permet ensuite de mettre en relation les cavités 110, 112 avec l'extérieur par l'intermédiaire des canaux 116, 122 et des trous 120, 126. En variante, les trous 120, 126 peuvent être réalisés après les canaux 116, 122 en ajoutant un niveau de lithographie et gravure.

La fermeture hermétique des cavités 110, 112 est ensuite réalisée comme précédemment décrit en liaison avec les figures 2 et 3 via des dépôts successifs de couches de fermeture bouchant les deuxièmes extrémités 117B, 123B des canaux 116, 122 se trouvant au niveau des trous 120, 126.

Afin d'obtenir une atmosphère bien maîtrisée dans les cavités 110, 112, il est possible de réaliser, avant le dépôt des couches de fermeture 128, 136, un étuvage des cavités 110, 112 sous vide à une température maximale compatible avec les matériaux en présence.

En variante du procédé de réalisation décrit ci-dessus, après la réalisation des canaux 116, 122 et des cavités 110, 112 par photolithographie et gravure du deuxième substrat, il est possible de réaliser un dépôt épais de matériau, par exemple un matériau polymère de type polyimide ou BCB (Benzocyclobutene), ou un matériau isolant tel que de l'oxyde de silicium déposé par CVD, comblant les cavités 110, 112 et les canaux 116, 122 précédemment définis dans le deuxième substrat. Une CMP permet ensuite d'aplanir la surface du capot 114 au niveau de laquelle est réalisé ce dépôt épais et qui est destinée à être rapportée directement sur le premier substrat 102 par collage direct. Après la solidarisation des deux substrats entre eux, l'amincissement éventuel du capot 114 et la gravure des trous 120, 126 dans le capot 114, le matériau comblant les cavités 110, 112 et les canaux 116, 122 est supprimé, par exemple via un plasma oxydant lorsque le matériau à supprimer est un polymère, ou un acide fluorhydrique sous forme vapeur lorsque le matériau à supprimer est de l'oxyde de silicium, à travers les trous 120, 126. La fermeture des cavités 110, 112 est ensuite réalisée comme précédemment décrit en bouchant les canaux 116, 122. Lorsque les micro-dispositifs sont réalisés à partir d'une couche sacrificielle de nature similaire à celle utilisée pour combler les canaux et les cavités dans le capot, il est ainsi possible de libérer simultanément les cavités et les dispositifs après assemblage. Ceux-ci sont donc protégés tout au long de leur fabrication. Cette variante permet également de mettre en oeuvre un scellement direct Si/Si ou métal/métal, et donc d'éviter la pollution des cavités par des gaz qui seraient issus par exemple de la fusion d'alliage de brasure.

Selon une autre variante du procédé de réalisation de la structure 100, les parties du capot 114 formants les différentes cavités 110, 112 et leurs canaux associés 116, 122 peuvent être individualisées, par exemple par une découpe du deuxième substrat avant leur assemblage sur le substrat 102. Ces capots individuels peuvent être ensuite reportés et assemblés sur le substrat 102 par exemple en utilisant des alliages de brasure fusible à basse température (par exemple à base de plomb, d'étain ou d'indium) ou par scellement direct métal/métal (par exemple Cu/Cu). Les canaux sont bouchés par les dépôts successifs 128 et 136.

En variante du premier mode de réalisation précédemment décrit dans lequel les canaux 116 et 122 sont réalisés en gravant le deuxième substrat formant le capot 114, ces canaux 116 et 112 peuvent être formés dans l'épaisseur de l'interface de collage entre le substrat 114 et le substrat 102. Ainsi, un cordon de scellement, par exemple à base d'alliage de brasure fusible (Au-Sn, Au-Si, Al-Ge) ou avantageusement d'un métal permettant un scellement direct (Cu, Ti, W) peut réaliser la solidarisation des deux substrats entre eux, les canaux 116, 122 étant réalisés au sein de ce cordon de scellement dont l'épaisseur est par exemple au moins égale à la plus grande hauteur des canaux. Il est également possible que les canaux soient réalisés en partie dans l'interface de collage et dans le substrat 102 et/ou dans le deuxième substrat.

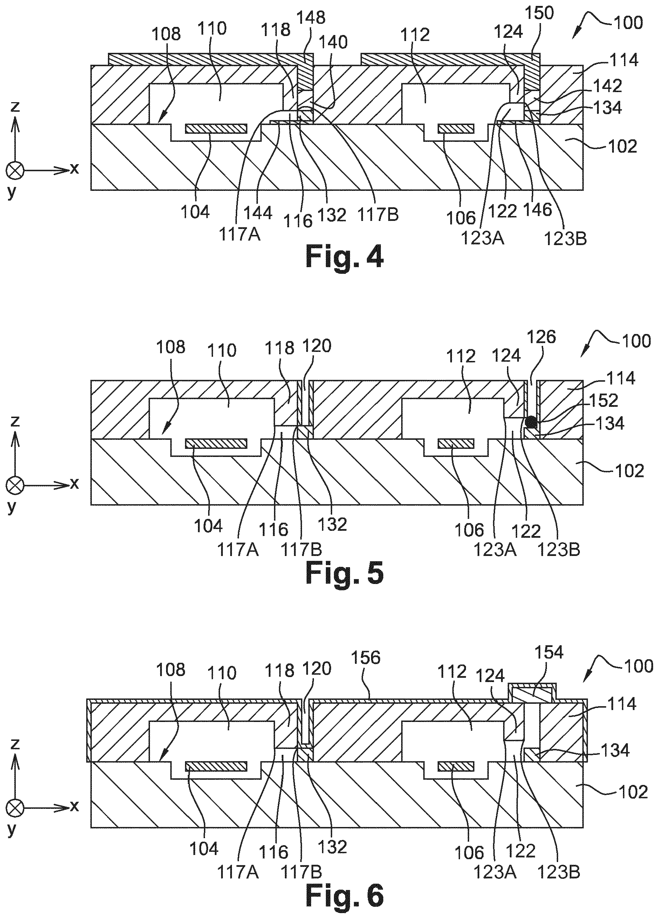

La figure 4 est une vue en coupe de la structure 100 selon le premier mode de réalisation dans laquelle les cavités 110, 112 sont fermées d'une manière différente de celle précédemment décrite en liaison avec les figures 2 et 3.

Dans cette variante, des éléments de connexion électrique 144 et 146 sont disposés sur la face avant 108 du substrat 102 (une couche isolante diélectrique, non représentée sur la figure 4, est toutefois disposée entre ces éléments 144 et 146 et le substrat 102) et sont chacun reliés électriquement aux micro-dispositifs 104 et 106 respectivement. Les éléments 144, 146 comportent chacun une partie disposée en regard d'un des trous 120 et 126 telle que les parties 132, 134, 140, 142 des couches de fermeture déposées soient en contact avec les éléments 144 et 146. Les couches de fermeture utilisées ici comportent au moins un matériau électriquement conducteur tel qu'un métal, les micro-dispositifs 104 et 106 étant donc reliés électriquement à ces parties 132, 134, 140 et 142 via les éléments 144, 146. Les parties 140 et 142 de la deuxième couche de fermeture servent également de couche de germination pour la mise en oeuvre d'un dépôt par électrodéposition ou tout autre dépôt permettant de remplir les trous 120, 126 d'un matériau électriquement conducteur, avantageusement du cuivre, et former ainsi des contacts électriques 148, 150 reliés aux micro-dispositifs 104 et 106 et accessibles depuis l'extérieur des cavités 110 et 112.

Pour cette variante, le capot 114 peut être recouvert d'un matériau diélectrique (par exemple de l'oxyde ou du nitrure de silicium) préalablement à la mise en oeuvre des dépôts des couches de fermeture, avantageusement via un dépôt CVD avec une épaisseur inférieure à la plus petite hauteur des canaux 116, 122. Le matériau de la première couche de fermeture formant les parties 132 et 134 est un métal déposé par exemple par PVD sous pression de gaz porteur contrôlée (argon, krypton). Le matériau de la deuxième couche de fermeture formant les parties 140 et 142 est métallique et apte à servir de couche de germination pour un dépôt électrolytique ultérieur des matériaux des contacts électriques 148 et 150, par exemple de l'or, du cuivre, du nickel, etc. Préalablement à la réalisation des contacts électriques 148, 150, les parties des couches de fermeture déposées sur le deuxième substrat (correspondant aux parties 130 et 138 sur l'exemple de la figure 3) peuvent être supprimées par exemple via une CMP. Les portions des contacts 148 et 150 ainsi obtenues se trouvant sur la face supérieure du capot 114 (face opposée à celle en regard avec la face supérieure 108 du substrat 102) se trouvent dans les trous 120, 126. Il est ensuite possible de reconstruire, sur la face supérieure du capot 114, un réseau de lignes électriques en vue de réaliser une interconnexion de la structure 100 avec une puce ou un autre substrat. Dans une autre variante, il est possible de faire une CMP sur la couche 138 afin d'effectuer ensuite une photolithographie et une gravure d'un réseau de lignes électriques sur la face supérieure du capot 114.

La figure 5 est une vue en coupe schématique de la structure 100 selon le premier mode de réalisation et dans laquelle les cavités 110, 112 sont fermées d'une manière différente à celles précédemment décrites en liaison avec les figures 2 à 4.

Comme pour la structure 100 précédemment décrite en liaison avec les figures 2 et 3, le canal 116 dont la hauteur $H_A$ est la plus petite est bouché au niveau de sa deuxième extrémité 117B via le dépôt de la première couche de fermeture d'épaisseur $E_1$ supérieure à la hauteur $H_A$ du canal 116 (et inférieure à la hauteur $H_B$ du canal 122 afin que celui-ci ne soit pas bouché lors du dépôt de cette première couche de fermeture). Une partie 132 de cette première couche de fermeture est déposée dans le trou 120 et bouche le canal 116. Une autre partie 134 de cette première couche de fermeture est déposée dans le trou 126 mais de bouche pas le canal 122. La première couche de fermeture comporte ici un matériau métallique qui recouvre également les parois latérales des trous 120 et 126. De plus, les parties de cette première couche de fermeture déposées sur la face du capot 114, en dehors des trous 120, 126, sont supprimées.

Contrairement à la structure 100 précédemment décrite en liaison avec la figure 3 dans laquelle le canal 122 est bouché via le dépôt d'une deuxième couche de fermeture, le canal 122 est ici bouché au niveau de sa deuxième extrémité 123B en introduisant dans le trou 126 une bille 152 de matériau de brasage, ou matériau fusible, dont le diamètre est inférieur au diamètre (ou aux dimensions parallèles au plan (X,Y)) du trou 126. Le diamètre de la bille 152 est également supérieur à la hauteur restante ($H_B - E_1$) non bouchée du canal 122 afin que cette bille 152 ne puisse pas passer dans le canal 122. Le brasage de cette bille 152 sous une atmosphère choisie permet de boucher le canal 122, et ferme la cavité 112, grâce au mouillage des parois latérales du trou 126 et de la partie 134 par le matériau de brasage. Un tel bouchage du canal 122 permet d'atteindre des niveaux de pression plus élevés que ceux pouvant être atteints via le dépôt de la deuxième couche de fermeture 136 comme précédemment décrit en liaison avec les figures 3 et 4.

La première couche de fermeture comporte par exemple de l'or et la bille 152 comporte un métal ou un alliage fusible tel que de l'indium, de l'AuSn, du Sn, etc. Si un matériau de brasage est utilisé pour solidariser le capot 114 au substrat 102, le matériau de la bille 152 est choisi tel que son point de fusion soit inférieur à celui du matériau de brasage solidarisant les substrats afin que le brasage de la bille 152 n'entraîne pas une refonte du matériau solidarisant les deux substrats.

La figure 6 est une vue en coupe schématique de la structure d'encapsulation 100 selon le premier mode de réalisation dans laquelle les cavités 110, 112 sont fermées d'une manière différente à celles précédemment décrites en liaison avec les figures 2 à 5.

Comme pour la structure 100 précédemment décrite en liaison avec les figures 2 et 3, le canal 116 dont la hauteur $H_A$ est la plus petite est bouché au niveau de sa deuxième extrémité 117B via le dépôt d'une première couche de fermeture d'épaisseur $E_1$ supérieure à la hauteur $H_A$ du canal 116 (et inférieure à la hauteur $H_B$ du canal 122 afin qu'il ne soit pas bouché lors du dépôt de cette première couche de fermeture). Une partie 132 de cette première couche de fermeture est déposée dans le trou 120 et bouche le canal 116. Une autre partie 134 de cette première couche de fermeture est déposée dans le trou 126 mais de bouche pas le canal 122. Les parties de cette première couche de fermeture déposées sur la face du capot 114 en dehors des trous 120, 126 sont supprimées.

Dans cette variante de réalisation, le canal 122 est bouché via un dépôt d'un film sec en polymère dont l'épaisseur est par exemple comprise entre quelques microns et environ 100 $\mu$m, avantageusement photosensible, par exemple laminé sur la face supérieure du capot 114 sous l'atmosphère voulue à une pression inférieure à environ 1 bar. Ce film sec est ensuite gravé afin qu'au moins une portion restante 154 soit disposée à l'aplomb du trou 126 et forme un bouchon au niveau du trou 126 sur la face supérieure du capot 114. L'ensemble précédemment réalisé est ensuite recouvert d'une couche hermétique 156 déposée sur le capot 114, recouvrant notamment les parois du trou 120, la partie 132 de la première couche de fermeture se trouvant dans le trou 120 et la portion 154. La couche 156 comporte par exemple de l'oxyde ou du nitrure de silicium, et/ou un métal obtenu par PVD ou CVD (éventuellement consolidé par un dépôt ECD) et dont l'épaisseur peut être comprise entre environ 0,1 $\mu$m et 10 $\mu$m.

Dans les structures précédemment décrites, une ou plusieurs portions de matériau getter peuvent être disposées dans l'une ou les deux cavités 110, 112, sur une ou plusieurs des parois des cavités, afin par exemple d'obtenir des plus basses pressions dans les cavités.

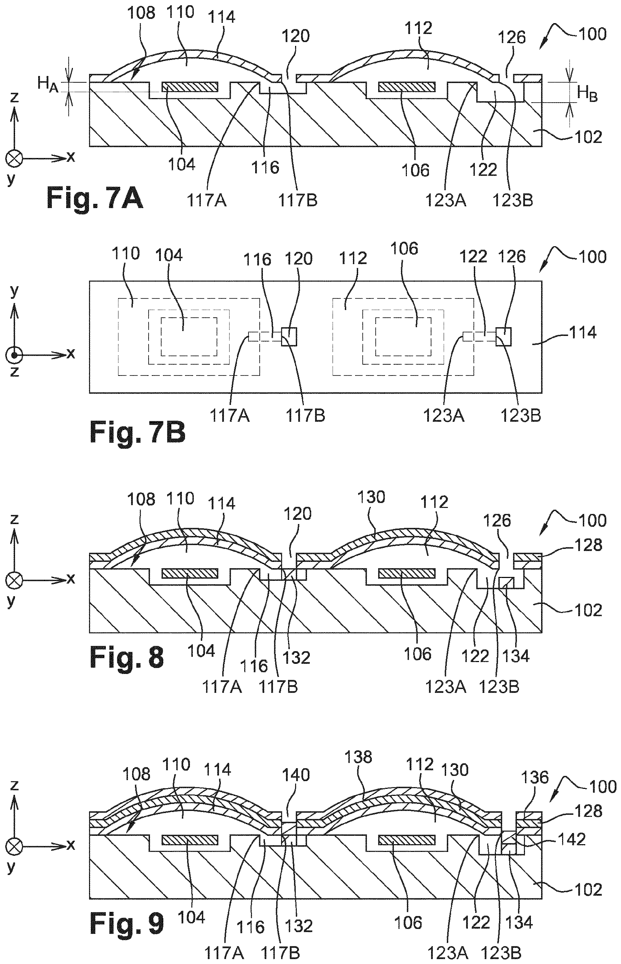

Les figures 7A et 7B représentent schématiquement une structure d'encapsulation 100 selon un deuxième mode de réalisation (la figure 7A est une vue en coupe de profil et la figure 7B est une vue de dessus de la structure 100).

Par rapport au premier mode de réalisation précédemment décrit, le capot 114 de la structure 100 selon le deuxième mode de réalisation ne correspond pas à un deuxième substrat mais à une ou plusieurs couches minces déposées sur la face avant 108 du substrat 102 (encapsulation TFP). Les cavités 110 et 112 sont formées via des portions de matériau sacrificiel dont les volumes correspondent à ceux des cavités 110 et 112 destinées à être réalisées et sur lesquelles la ou les couches minces formant le capot 114 sont déposées.

Comme dans le premier mode de réalisation, l'accès à l'intérieur de chacune des cavités 110 et 112 de la structure 100 est réalisé via un canal s'étendant latéralement tel qu'il débouche sur un côté de l'une des cavités 110, 112. Dans ce deuxième mode de réalisation, les canaux 116, 122 sont formés dans le substrat 102. Les trous 120, 126 réalisés à travers le capot 114 font communiquer les canaux 116, 122 avec l'environnement extérieur de la structure 100. Sur l'exemple des figures 7A et 7B, le premier canal 116 est formé par une première partie gravée du substrat 102, au niveau de la face avant 108 du substrat 102, et débouche dans la première cavité 110 au niveau d'un côté de celle-ci, au niveau de sa première extrémité 117A. Le premier canal 116 communique avec le premier trou 120 formé à travers la ou les couches minces du capot 114, au niveau de sa deuxième extrémité 117B. De même, le deuxième canal 122 est formé par une deuxième partie gravée du substrat 102, au niveau de sa face avant 108, et débouche dans la deuxième cavité 112 au niveau d'un côté de celle-ci, au niveau de sa première extrémité 123A. Le canal 122 communique avec le deuxième trou 126 formé à travers la ou les couches minces du capot 114, au niveau de sa deuxième extrémité 123B.

Sur l'exemple des figures 7A et 7B, les canaux 116 et 122 s'étendent horizontalement dans le substrat 102, c'est-à-dire s'étendent selon une direction parallèle à la face avant 108 du substrat 102 (parallèlement à l'axe X sur les figures 7A et 7B), depuis la première extrémité 117A, 123A jusqu'à la deuxième extrémité 117B, 123B. Les trous 120 et 126 s'étendent verticalement à travers le capot 114, c'est-à-dire perpendiculairement à la face avant 108 du substrat 102 et également perpendiculairement à la face extérieure du capot 114 au niveau de laquelle les trous 120 et 126 débouchent (parallèlement à l'axe Z sur les figures 7A et 7B). Les trous 120, 126 s'étendent dans une direction perpendiculaire à celle selon laquelle s'étendent les canaux 116, 122.

Comme dans le premier mode de réalisation, afin de pouvoir fermer successivement les cavités 110 et 112 avec des atmosphères différentes, les canaux 116 et 122 ont des hauteurs $H_A$ et $H_B$ différentes, avec $H_A <$ $H_B$. Les gravures du substrat 102 formant les canaux 116 et 122 sont donc réalisées à des profondeurs différentes afin d'obtenir ces hauteurs de canaux différentes.

La figure 8 représente une première étape mise en oeuvre lors d'une fermeture hermétique des cavités 110 et 112. Comme dans le premier mode de réalisation, la première couche de fermeture 128 est déposée, par exemple par un dépôt PVD, sur la structure 100. Des parties 130 de cette couche 128 sont déposées sur le capot 114 et d'autres parties 132, 134 sont déposées dans les trous 120 et 126. De plus, afin que le dépôt de cette couche 128 ferme hermétiquement la cavité 110 (au niveau de la deuxième extrémité 117B du canal 116) mais ne ferme pas la cavité 112, l'épaisseur $E_1$ de la couche 128 est choisie telle que $H_A < E_1 < H_B$. La partie 134 déposée dans le trou 126 ne bouche pas le canal 122 dont la hauteur $H_B$ est supérieure à l'épaisseur $E_1$. Cette étape de dépôt de la couche 128 est mise en oeuvre sous une atmosphère correspondant à celle souhaitée dans la cavité 110, en termes de nature de gaz et de pression, afin que cette atmosphère se retrouve dans la cavité 110 après le dépôt de la couche 128.

La figure 9 représente une deuxième étape mise en oeuvre lors de la fermeture hermétique des cavités 110 et 112. Lors de cette deuxième étape, la deuxième couche de fermeture 136 est déposée sur la couche 128. Ainsi, des parties 138 de cette couche 136 sont déposées au niveau du capot 114, sur les portions 130, et d'autres parties 140, 142 sont déposées dans les trous 120 et 126, respectivement sur les parties 132 et 134 de la couche 128. Ainsi, la partie 142 de la couche 136 déposée dans le trou 126, sur la partie 134 de la couche 128, bouche le canal 122 au niveau de sa deuxième extrémité 123B et dont la hauteur $H_B$ est inférieure à la somme des épaisseurs $E_1$ et $E_2$. Cette étape de dépôt de la couche 136 est mise en oeuvre sous une atmosphère correspondant à celle souhaitée dans la cavité 112 afin que cette atmosphère se retrouve dans la cavité 112 après le dépôt de la couche 136. De plus, étant donné la faible épaisseur du capot 114, les trous 120 et 126 sont ici complètement bouchés par les portions 132, 134, 140 et 142.

Les deux couches de fermeture 128 et 136 utilisées dans ce deuxième mode de réalisation sont par exemple similaires à celles précédemment décrites en liaison avec le premier mode de réalisation.

Préalablement à la mise en oeuvre des étapes de dépôt des couches 128 et 136, la structure 100 selon le deuxième mode de réalisation est par exemple réalisée par la mise en oeuvre des étapes décrites ci-dessous.

Les micro-dispositifs 104 et 106 sont tout d'abord réalisés dans le substrat 102.

Les canaux 116 et 122 sont ensuite réalisés dans le substrat 102 par photolithographie et gravure.

Une couche de matériau sacrificiel, comportant par exemple un polymère et d'épaisseur comprise entre environ 1 $\mu$m et 100 $\mu$m, est ensuite déposée sur la face avant 108 du substrat 102, en recouvrant les micro-dispositifs 104 et 106. Le matériau sacrificiel peut être une résine photosensible qui est mise en forme par insolation à travers un masque et gravée telle que des portions restantes de ce matériau sacrificiel correspondent aux volumes des cavités 110 et 112 destinées à être réalisées. Chacune des portions restantes du matériau sacrificiel recouvre au moins une partie d'un des canaux 116 et 122. La couche mince (ou les couches minces) formant le capot 114 est ensuite déposée sur le substrat 102 en recouvrant les portions de matériau sacrificiel. Cette couche mince peut comporter un diélectrique ($SiO_2$ ou SiN par exemple) déposé par exemple par CVD, ou un métal déposé par PVD. Plusieurs couches minces peuvent être déposées successivement pour former le capot 114, ces couches pouvant être de natures différentes les unes par rapport aux autres. La couche mince ou chacune des couches minces peut comporter une épaisseur comprise entre environ 1 $\mu$m et quelques microns.

Les trous 120 et 126 sont ensuite réalisés à travers le capot 114, puis le matériau sacrificiel se trouvant sous le capot 114 est gravé à travers ces trous, par exemple via un plasma oxydant. Outre la suppression du matériau sacrificiel formant les cavités 110, 112, cette étape de gravure peut également libérer les micro-dispositifs 104, 106 si du matériau sacrificiel est présent autour de ces micro-dispositifs à ce stade du procédé.

Les canaux 116, 122 sont ensuite bouchés comme précédemment décrit en liaison avec les figures 8 et 9.

En variante du deuxième mode de réalisation dans lequel les canaux 116 et 122 sont réalisés dans des parties gravées du substrat 102, ces canaux peuvent être réalisés dans les couches minces formant le capot 114.

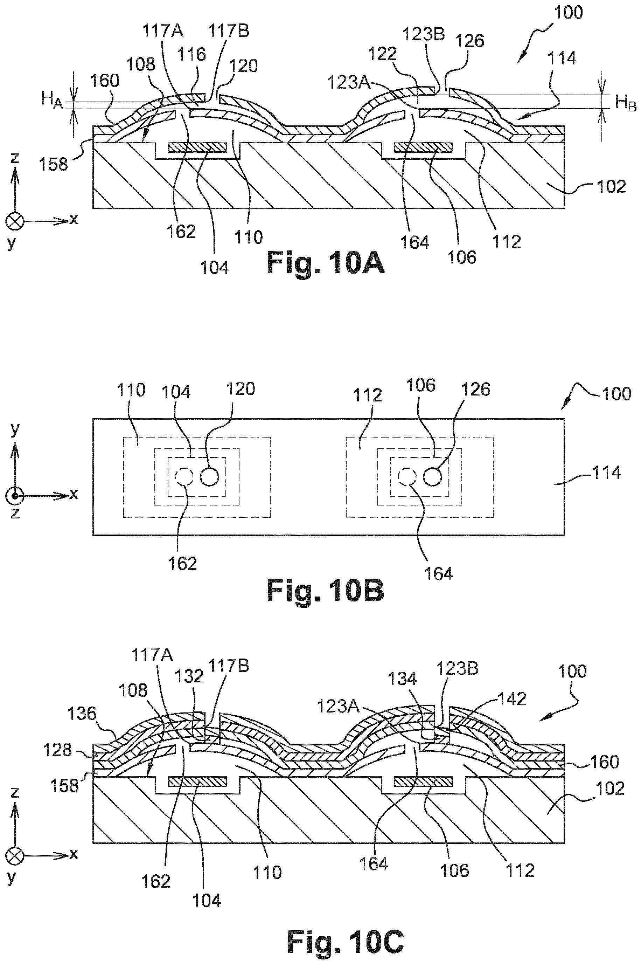

La figure 10A représente un tel capot 114 dans lequel les canaux 116 et 122 sont réalisés. Le capot 114 est formé par au moins deux couches minces superposées l'une au-dessus de l'autre, ici une première couche inférieure 158 et une deuxième couche supérieure 160.

Pour la partie du capot 114 formée au niveau de la première cavité 110, le trou 120 est réalisé à travers la couche 160. Le canal 116 est formé par un espace de hauteur $H_A$ se trouvant entre les deux couches 158 et 160. Le canal 116 communique avec l'extérieur de la cavité 110 par l'intermédiaire du trou 120. Un trou 162 réalisé à travers la couche 158 et fait communiquer le canal 116 avec l'intérieur de la cavité 110.

Pour la partie du capot 114 formée au niveau de la deuxième cavité 112 destinée à être fermée ultérieurement à la première cavité 110, le trou 126 est réalisé à travers la couche 160. Le canal 122 est formé par un espace de hauteur $H_B$ se trouvant entre les deux couches 158 et 160. Le canal 122 communique avec l'extérieur de la cavité 112 par l'intermédiaire du trou 126. Un trou 164 réalisé à travers la couche 158 fait communiquer le canal 122 avec l'intérieur de la cavité 112.

Les trous 162 et 164 ont par exemple, dans un plan parallèle à la face avant 108 du substrat 102 (plan parallèle au plan (X,Y)), des sections de forme et de dimensions similaires à ceux des trous 120 et 126.

La figure 10B représente une vue de dessus d'une telle structure 100.

La figure 10C représente la structure 100 dans laquelle le canal 116 est bouché, au niveau de sa deuxième extrémité 117B, vis-à-vis de l'extérieur par la partie 132 de la première couche de fermeture, et le canal 122 est bouché, au niveau de sa deuxième extrémité 123B, vis-à-vis de l'extérieur par les parties 134 et 142 des deux couches de fermeture.

Un tel capot 114 peut être réalisé en déposant la première couche 158 sur les portions de matériau sacrificiel définissant les volumes des cavités 110, 112. Les trous 162 et 164 sont ensuite réalisés par photolithographie et gravure à travers la couche 158. Une première couche de matériau sacrificiel, par exemple en résine et de préférence de même nature que le matériau des portions définissant les volumes des cavités 110, 112, est ensuite déposée sur la couche 158. Cette première couche de matériau sacrificiel a une épaisseur égale à $H_A$. Une photolithographie et une gravure de cette première couche de matériau sacrificiel sont ensuite réalisées afin de conserver une portion restante de cette première couche de matériau sacrificiel uniquement au niveau du canal 116. Une deuxième couche de matériau sacrificiel d'épaisseur égale à $H_B$ est ensuite déposée au niveau du canal 122 sur les parties de la couche 158 qui ne sont pas recouvertes par cette portion restante. Ainsi, l'épaisseur de matériau sacrificiel présent sur la couche 158 est modulée selon les hauteurs des canaux désirées. Des résines photosensibles de polarités opposées sont avantageusement utilisées pour réaliser les première et deuxième couches de matériau sacrificiel. La couche 160 est ensuite déposée sur ces matériaux sacrificiels. Les trous 120 et 126 sont réalisés à travers la couche 160 par photolithographie et gravure. Le matériau sacrificiel se trouvant entre les deux couches 158 et 160 ainsi que le matériau sacrificiel présent sous la couche 158 sont ensuite gravés, par exemple par un plasma oxydant, à travers les trous 120 et 126. Les canaux sont ensuite bouchés comme précédemment décrit.

Dans tous les modes de réalisation et variantes précédemment décrits, pour des micro-dispositifs destinés à fonctionner sous un vide très poussé, par exemple inférieur à environ 10⁻⁴ mbar, les canaux peuvent être bouchés sous vide secondaire par un dépôt métallique, par exemple un matériau getter tel que du titane ou du zirconium. Il est également possible que la première couche de fermeture 128 et/ou la ou les couches minces formant le capot dans le deuxième mode de réalisation comportent au moins un matériau getter. L'utilisation d'un matériau getter pour réaliser le bouchage d'un ou plusieurs canaux permet d'obtenir des vides plus poussés, par exemple proche d'environ 10⁻⁶ mbar, grâce à l'absorption / adsorption des gaz réalisée par le getter.

Dans les modes de réalisation et variantes précédemment décrits, deux cavités distinctes sont fermées successivement, la première cavité étant fermée via un premier dépôt qui ferme hermétiquement une seule des deux cavités. La deuxième cavité est ensuite fermée hermétiquement par une étape distincte. De manière générale, la structure 100 peut comporter n cavités, avec n qui peut être un nombre entier supérieur ou égal à 2. Chacune de ces n cavités comporte un canal formant un accès à la cavité, les canaux ayant des hauteurs différentes les unes par rapport aux autres. Certains canaux peuvent avoir des hauteurs similaires. Ainsi, les n canaux peuvent être réalisés avec m hauteurs différentes, avec $2 \leq m \leq n$. Ces canaux peuvent être bouchés hermétiquement par la mise en oeuvre de m dépôts successifs de matériau de fermeture, chaque dépôt fermant hermétiquement une cavité ou plusieurs cavités via le bouchage des canaux d'accès qui ont des hauteurs similaires. En considérant n canaux de hauteurs $H_1$ à $H_m$, les m dépôts successifs de hauteurs $E_1$ à $E_m$ sont donc tels

que $H_i < \sum_{j=1}^{m-1} E_j < H_{i+1} < \sum_{j=1}^{m} E_j$ .

## Revendications

1. Structure d'encapsulation (100) comportant :

   - au moins un capot (114) solidarisé à au moins un premier substrat (102) et formant au moins des première (110) et deuxième (112) cavités distinctes entre le capot (114) et le premier substrat (102),
   - au moins des premier (116) et deuxième (122) canaux formés dans le premier substrat (102) et/ou dans le capot (114) et/ou entre le premier substrat (102) et le capot (114), tels que le premier canal (116) comporte une première extrémité (117A) débouchant dans la première cavité (110) et une deuxième extrémité (117B) débouchant hors de la première cavité (110) par l'intermédiaire d'au moins un premier trou (120) formé à travers le capot (114), et que le deuxième canal (122) comporte une première extrémité (123A) débouchant dans la deuxième cavité (112) et une deuxième extrémité (123B) débouchant hors de la deuxième cavité (112) par l'intermédiaire d'au moins un deuxième trou (126) formé à travers le capot (114),

dans laquelle une hauteur $H_A$ du premier canal (116) au niveau de sa deuxième extrémité (117B) est inférieure à une hauteur $H_B$ du deuxième canal (122) au niveau de sa deuxième extrémité (123B), et dans laquelle au moins une première couche de fermeture (128) d'épaisseur $E_1$ supérieure à la hauteur $H_A$ et inférieure à la hauteur $H_B$ ferme le premier canal (116) sans fermer le deuxième canal (122), et dans laquelle le deuxième canal (122) est fermé, les atmosphères dans les première et deuxième cavités (110, 112) étant différentes en terme de pression et/ou de nature de gaz.

2. Structure d'encapsulation (100) selon la revendication 1, dans laquelle la différence entre les hauteurs $H_A$ et $H_B$ est telle qu'il est possible de fermer le premier canal (116) via le dépôt de la première couche de fermeture (128) au niveau des deuxièmes extrémités (117B, 123B) des premier et deuxième canaux (116, 122) sans fermer le deuxième canal (122).

3. Structure d'encapsulation (100) selon l'une des revendications précédentes, dans laquelle la deuxième extrémité (117B) du premier canal (116) est bouchée par au moins une première portion (132) de la première couche de fermeture (128) d'épaisseur $E_1$ supérieure à la hauteur $H_A$ et inférieure à la hauteur $H_B$, et dans laquelle la deuxième extrémité (123B) du deuxième canal (122) est bouchée par au moins :

   - une deuxième portion (134) de la première couche de fermeture (128) et une portion (142) d'une deuxième couche de fermeture (136) d'épaisseur $E_2$ telle que $H_B < (E_1 + E_2)$, ou
   - la deuxième portion (134) de la première couche de fermeture (128) et une portion (142) de matériau brasée sur la deuxième portion (134) de la première couche de fermeture (128) et d'épaisseur $E_2$ telle que $H_B < (E_1 + E_2)$, ou
   - la deuxième portion (134) de la première couche de fermeture (128) et une portion (154, 156) de couche de bouchage bouchant le deuxième trou (126) sur le capot (114).

4. Structure d'encapsulation (100) selon l'une des revendications précédentes, dans laquelle au moins un premier micro-dispositif (104) est disposé dans la première cavité (110) et/ou dans laquelle au moins un deuxième micro-dispositif (106) est disposé dans la deuxième cavité (112).

5. Structure d'encapsulation (100) selon les revendications 3 et 4, dans laquelle :

   - lorsque le premier micro-dispositif (104) est disposé dans la première cavité (110), la première couche de fermeture (128) comporte au moins un matériau électriquement conducteur, la structure d'encapsulation (100) comportant au moins un premier élément de connexion électrique (144) relié au premier micro-dispositif (104) et à la première portion (132) de la première couche de fermeture (128), et au moins un premier contact électrique (148) disposé au moins en partie dans le premier trou (120) et relié à la première portion (132) de la première couche de fermeture (128), et/ou
   - lorsque le deuxième micro-dispositif (106) est disposé dans la deuxième cavité (112), les matériaux (134, 142) bouchant la deuxième extrémité (123B) du deuxième canal (122) sont électriquement conducteurs, la structure d'encapsulation (100) comportant au moins un deuxième élément de connexion électrique (146) relié au deuxième micro-dispositif (106) et à la deuxième portion (134) de la première couche de fermeture (128), et au moins un deuxième contact électrique (146) disposé au moins en partie dans le deuxième trou (126) et relié à la portion (142) de la deuxième couche de fermeture (136) ou à la portion (152) de matériau brasée sur la deuxième portion (134) de la première couche de fermeture (128).

6. Structure d'encapsulation (100) selon l'une des revendications précédentes, dans laquelle le premier canal (116) traverse au moins une paroi latérale (118) de la première cavité (110) et/ou dans laquelle le deuxième canal (122) traverse au moins une paroi latérale (124) de la deuxième cavité (112).

7. Structure d'encapsulation (100) selon l'une des revendications précédentes, dans laquelle le capot (114) comporte au moins un substrat dit deuxième substrat solidarisé au premier substrat (102) et tel que les première (110) et deuxième (112) cavités sont formées au moins en partie dans le deuxième substrat.

8. Structure d'encapsulation (100) selon la revendication 7, dans laquelle le deuxième substrat est solidarisé au premier substrat (102) par l'intermédiaire d'une interface de collage disposée entre le premier substrat (102) et le deuxième substrat et telle que les premier (116) et deuxième (122) canaux sont formés au moins en partie dans l'interface de collage.

9. Structure d'encapsulation (100) selon l'une des revendications 1 à 6, dans laquelle le capot (114) comporte au moins une couche mince disposée sur le premier substrat (102), et dans laquelle les premier (116) et deuxième (122) canaux sont formés au moins dans le premier substrat (102).

10. Structure d'encapsulation (100) selon l'une des revendications 1 à 5, dans laquelle le capot (114) comporte au moins deux couches minces (158, 160) superposées l'une au-dessus de l'autre et disposées sur le premier substrat (102), et dans laquelle les premier (116) et deuxième (122) canaux sont formés au moins par des espaces entre les deux couches minces (158, 160).

11. Procédé de réalisation d'une structure d'encapsulation (100), comportant au moins les étapes suivantes :

- réalisation d'au moins un capot (114) solidarisé à au moins un premier substrat (102) formant au moins des première (110) et deuxième (112) cavités distinctes entre le capot (114) et le premier substrat (102),
- réalisation d'au moins des premier (116) et deuxième (122) canaux dans le premier substrat (102) et/ou dans le capot (114) et/ou entre le premier substrat (102) et le capot (114), tels que le premier canal (116) comporte une première extrémité (117A) débouchant dans la première cavité (110) et une deuxième extrémité (117B) débouchant hors de la première cavité (110) par l'intermédiaire d'au moins un premier trou (120) formé à travers le capot (114), et que le deuxième canal (122) comporte une première extrémité (123A) débouchant dans la deuxième cavité (112) et une deuxième extrémité (123B) débouchant hors de la deuxième cavité (112) par l'intermédiaire d'au moins un deuxième trou (126) formé à travers le capot (114), dans lequel une hauteur $H_A$ du premier canal (116) au niveau de sa deuxième extrémité (117B) est inférieure à une hauteur $H_B$ du deuxième canal (122) au niveau de sa deuxième extrémité (123B),
- dépôt d'au moins une première couche de fermeture (128) d'épaisseur $E_1$ supérieure à la hauteur $H_A$ et inférieure à la hauteur $H_B$, fermant le premier canal (116) sans fermer le deuxième canal (122), puis
- fermeture du deuxième canal (122),

les atmosphères dans les première et deuxième cavités (110, 112) étant différentes en terme de pression et/ou de nature de gaz .

12. Procédé selon la revendication 11, dans lequel la première couche de fermeture (128) est déposée telle qu'au moins une première portion (132) de la première couche de fermeture (128) bouche la deuxième extrémité (117B) du premier canal (116), puis le deuxième canal (122) est fermé par :

- un dépôt d'au moins une deuxième couche de fermeture (136) d'épaisseur $E_2$ telle que $H_B < (E_1 + E_2)$ et qu'au moins une deuxième portion (134) de la première couche de fermeture (128) et une portion (142) de la deuxième couche de fermeture (136) bouche la deuxième extrémité (123B) du deuxième canal (122), ou
- un dépôt d'au moins une portion (152) de matériau de brasage d'épaisseur $E_2$ telle que $H_B < (E_1 + E_2)$ sur la deuxième portion (134) de la première couche de fermeture (128), puis un brasage de la portion (152) de matériau de brasage, ou
- la réalisation d'au moins une portion (154, 156) de couche de bouchage bouchant le deuxième trou (126) sur le capot (114).

13. Procédé selon l'une des revendications 11 ou 12, dans lequel la réalisation du capot (114) et des premier (116) et deuxième (122) canaux comporte au moins la mise en oeuvre des étapes suivantes :

- réalisation des premier (116) et deuxième (122) canaux au niveau d'une face d'un deuxième substrat destiné à être solidarisé au premier substrat (102) ;
- réalisation des première (110) et deuxième (112) cavités au niveau de ladite face du deuxième substrat ;
- solidarisation de ladite face du deuxième substrat au premier substrat (102) ;
- réalisation des premier (120) et deuxième (126) trous à travers le deuxième substrat,

dans lequel le premier canal (116) traverse au moins une paroi latérale (118) de la première cavité (110) et/ou dans lequel le deuxième canal (122) traverse au moins une paroi latérale (124) de la deuxième cavité (112).

14. Procédé selon l'une des revendications 11 ou 12, dans lequel la réalisation du capot (114) et des premier (116) et deuxième (122) canaux comporte au moins la mise en oeuvre des étapes suivantes :

- réalisation des première (110) et deuxième (112) cavités au niveau d'une face d'un deuxième substrat destiné à être solidarisé au premier substrat (102) ;
- réalisation d'une interface de collage sur ladite face du deuxième substrat et/ou sur une face (108) du premier substrat (102) à laquelle le deuxième substrat est destiné à être solidarisé, les premier (116) et deuxième (122) canaux étant formés au moins en partie dans l'interface de collage ;
- solidarisation de ladite face du deuxième substrat au premier substrat (102) par l'intermédiaire de l'interface de collage ;
- réalisation des premier (120) et deuxième (126) trous à travers le deuxième substrat.

**15.** Procédé selon l'une des revendications 11 ou 12, dans lequel la réalisation du capot (114) et des premier (116) et deuxième (122) canaux comporte au moins la mise en oeuvre des étapes suivantes :

- réalisation des premier (116) et deuxième (122) canaux dans le premier substrat (102) ;
- réalisation de première et deuxième portions de matériau sacrificiel sur le premier substrat (102), dont des volumes correspondent à ceux des première (110) et deuxième (112) cavités et telles que la première portion de matériau sacrificiel recouvre au moins une partie du premier canal (116) et que la deuxième portion de matériau sacrificiel recouvre au moins une partie du deuxième canal (122) ;
- dépôt d'au moins une couche mince sur les première et deuxième portions de matériau sacrificiel ;
- réalisation des premier (120) et deuxième (126) trous à travers la couche mince ;
- gravure des première et deuxième portions de matériau sacrificiel à travers les premier (120) et deuxième (126) trous.

**16.** Procédé selon l'une des revendications 11 ou 12, dans lequel la réalisation du capot (114) et des premier (116) et deuxième (122) canaux comporte au moins la mise en oeuvre des étapes suivantes :

- réalisation de première et deuxième portions de matériau sacrificiel sur le premier substrat (102), dont des volumes correspondent à ceux des première (110) et deuxième (112) cavités ;
- dépôt d'au moins une première couche mince (158) sur les première et deuxième portions de matériau sacrificiel ;
- réalisation de troisième (162) et quatrième (164) trous à travers la première couche mince (158), le troisième trou (162) étant formé au niveau d'un emplacement de la première extrémité (117A) du premier canal (116) destiné à être réalisé et le quatrième trou (164) étant formé au niveau d'un emplacement de la première extrémité (123A) du deuxième canal (122) destiné à être réalisé ;
- réalisation, sur la première couche mince (158), d'au moins une troisième portion de matériau sacrificiel dont une épaisseur est égale à la hauteur $H_A$, au moins au niveau d'un emplacement du premier canal (116), et d'au moins une quatrième portion de matériau sacrificiel dont une épaisseur est égale à la hauteur $H_B$, au moins au niveau d'un emplacement du deuxième canal (122) ;
- dépôt d'au moins une deuxième couche mince (160) sur la première couche mince (158), recouvrant les troisième et quatrième portions de matériau sacrificiel ;
- réalisation des premier (120) et deuxième (126) trous à travers la deuxième couche mince (160) ;
- gravure des première, deuxième, troisième et quatrième portions de matériau sacrificiel à travers au moins les premier (120) et deuxième (126) trous.

**Patentansprüche**

**1.** Einkapselungsstruktur (100), umfassend:

- wenigstens eine Abdeckung (114), die mit wenigstens einem ersten Substrat (102) verbunden ist und wenigstens erste (110) und zweite (112) unterschiedliche Hohlräume zwischen der Abdeckung (114) und dem ersten Substrat (102) bildet,
- wenigstens einen ersten (116) und einen zweiten (122) Kanal, die in dem ersten Substrat (102) und/oder in der Abdeckung (114) und/oder zwischen dem ersten Substrat (102) und der Abdeckung (114) derart gebildet sind, dass der erste Kanal (116) ein erstes Ende (117A) umfasst, das in den ersten Hohlraum (110) mündet, und ein zweites Ende (117B), das mittels wenigstens eines ersten Lochs (120), welches durch die Abdeckung (114) hindurch gebildet ist, außerhalb des ersten Hohlraums (110) mündet, und dass der zweite Kanal (122) ein erstes Ende (123A) umfasst, das in den zweiten Hohlraum (112) mündet, und ein zweites Ende (123B), das mittels wenigstens eines zweiten Lochs (126), welches durch die Abdeckung (114) hindurch gebildet ist, außerhalb des zweiten Hohlraums (112) mündet,

wobei eine Höhe $H_A$ des ersten Kanals (116) im Bereich seines zweiten Endes (117B) kleiner ist als eine Höhe $H_B$ des zweiten Kanals (122) im Bereich seines zweiten Endes (123B), und wobei wenigstens eine erste Abschlussschicht (128) mit einer Dicke $E_1$ größer als die Höhe $H_A$ und kleiner als die Höhe $H_B$ den ersten Kanal (116) schließt, ohne den zweiten Kanal (122) zu schließen, und wobei der zweite Kanal (122) geschlossen ist, wobei die Atmosphären in dem ersten und dem zweiten Hohlraum (110, 112) hinsichtlich des Drucks und/oder der Art des Gases verschieden sind.

**2.** Einkapselungsstruktur (100) nach Anspruch 1, wobei die Differenz zwischen den Höhen $H_A$ und $H_B$

derart ist, dass es möglich ist, den ersten Kanal (116) mittels der Aufbringung der ersten Abschlussschicht (128) im Bereich der zweiten Enden (117B, 123B) des ersten und des zweiten Kanals (116, 122) zu schließen, ohne den zweiten Kanal (122) zu schließen.

3.  Einkapselungsstruktur (100) nach einem der vorhergehenden Ansprüche, wobei das zweite Ende (117B) des ersten Kanals (116) durch wenigstens einen ersten Bereich (132) der ersten Abschlussschicht (128) mit einer Dicke $E_1$ größer als die Höhe $H_A$ und kleiner als die Höhe $H_B$ blockiert ist, und wobei das zweite Ende (123B) des zweiten Kanals (122) wenigstens durch Folgendes blockiert ist:

    - einen zweiten Bereich (134) der ersten Abschlussschicht (128) und einen Bereich (142) einer zweiten Abschlussschicht (136) mit einer Dicke $E_2$ derart, dass $H_B < (E_1 + E_2)$, oder
    - den zweiten Bereich (134) der ersten Abschlussschicht (128) und einen Bereich (142) von Material, der auf den zweiten Bereich (134) der ersten Abschlussschicht (128) gelötet ist und mit einer Dicke $E_2$ derart, dass $H_B < (E_1 + E_2)$, oder
    - den zweiten Bereich (134) der ersten Abschlussschicht (128) und einen Bereich (154, 156) einer Blockierschicht, die das zweite Loch (126) auf der Abdeckung (114) blockiert.

4.  Einkapselungsstruktur (100) nach einem der vorhergehenden Ansprüche, wobei wenigstens eine erste Mikrovorrichtung (104) in dem ersten Hohlraum (110) angeordnet ist, und/oder wobei wenigstens eine zweite Mikrovorrichtung (106) in dem zweiten Hohlraum (112) angeordnet ist.

5.  Einkapselungsstruktur (100) nach den Ansprüchen 3 und 4, wobei:

    - wenn die erste Mikrovorrichtung (104) in dem ersten Hohlraum (110) angeordnet ist, die erste Abschlussschicht (128) wenigstens ein elektrisch leitendes Material umfasst, wobei die Einkapselungsstruktur (100) wenigstens ein erstes elektrisches Verbindungselement (144) umfasst, das mit der ersten Mikrovorrichtung (104) und mit dem ersten Bereich (132) der ersten Abschlussschicht (128) verbunden ist, und wenigstens einen ersten elektrischen Kontakt (148), der wenigstens teilweise in dem ersten Loch (120) angeordnet und mit dem ersten Bereich (132) der ersten Abschlussschicht (128) verbunden ist, und/oder
    - wenn die zweite Mikrovorrichtung (106) im dem zweiten Hohlraum (112) angeordnet ist, die Materialien (134, 142), die das zweite Ende (123B) des zweiten Kanals (122) blockieren, elektrisch leitend sind, wobei die Einkapselungsstruktur (100) wenigstens ein zweites elektrisches Verbindungselement (146) umfasst, das mit der zweiten Mikrovorrichtung (106) und mit dem zweiten Bereich (134) der ersten Abschlussschicht (128) verbunden ist, und wenigstens einen zweiten elektrischen Kontakt (146), der wenigstens teilweise in dem zweiten Loch (126) angeordnet und mit dem Bereich (142) der zweiten Abschlussschicht (136) oder mit dem Bereich (152) von Material verbunden ist, der auf den zweiten Bereich (134) der ersten Abschlussschicht (128) gelötet ist.

6.  Einkapselungsstruktur (100) nach einem der vorhergehenden Ansprüche, wobei der erste Kanal (116) wenigstens eine Seitenwand (118) des ersten Hohlraums (110) durchsetzt, und/oder wobei der zweite Kanal (122) wenigstens eine Seitenwand (124) des zweiten Hohlraums (112) durchsetzt.

7.  Einkapselungsstruktur (100) nach einem der vorhergehenden Ansprüche, wobei die Abdeckung (114) wenigstens ein Substrat umfasst, genannt zweites Substrat, das mit dem ersten Substrat (102) verbunden ist, und derart, dass der erste (110) und der zweite (112) Hohlraum wenigstens teilweise in dem zweiten Substrat gebildet sind.

8.  Einkapselungsstruktur (100) nach Anspruch 7, wobei das zweite Substrat mit dem ersten Substrat (102) mittels einer Verklebungsgrenzfläche verbunden ist, die zwischen dem ersten Substrat (102) und dem zweiten Substrat angeordnet ist, und derart, dass der erste (116) und der zweite (122) Kanal wenigstens teilweise in der Verklebungsgrenzfläche gebildet sind.

9.  Einkapselungsstruktur (100) nach einem der Ansprüche 1 bis 6, wobei die Abdeckung (114) wenigstens eine dünne Schicht umfasst, die auf dem ersten Substrat (102) angeordnet ist, und wobei der erste (116) und der zweite (122) Kanal wenigstens in dem ersten Substrat (102) gebildet sind.

10. Einkapselungsstruktur (100) nach einem der Ansprüche 1 bis 5, wobei die Abdeckung (114) wenigstens zwei dünne Schichten (158, 160) umfasst, die einander überlagert und auf dem ersten Substrat (102) angeordnet sind, und wobei der erste (116) und der zweite (122) Kanal wenigstens durch Räume zwischen den zwei dünnen Schichten (158, 160) gebildet sind.

11. Verfahren zur Herstellung einer Einkapselungsstruktur (100), umfassend wenigstens die folgenden Schritte:

- Herstellen wenigstens einer Abdeckung (114), die mit wenigstens einem ersten Substrat (102) verbunden ist, wodurch wenigstens erste (110) und zweite (112) unterschiedliche Hohlräume zwischen der Abdeckung (114) und dem ersten Substrat (102) gebildet werden,
- Herstellen wenigstens eines ersten (116) und eines zweiten (122) Kanals in dem ersten Substrat (102) und/oder in der Abdeckung (114) und/oder zwischen dem ersten Substrat (102) und der Abdeckung (114) derart, dass der erste Kanal (116) ein erstes Ende (117A) umfasst, das in den ersten Hohlraum (110) mündet, und ein zweites Ende (117B), das mittels wenigstens eines ersten Lochs (120), welches durch die Abdeckung (114) hindurch gebildet ist, außerhalb des ersten Hohlraums (110) mündet, und dass der zweite Kanal (122) ein erstes Ende (123A) umfasst, das in den zweiten Hohlraum (112) mündet, und ein zweites Ende (123B), das mittels wenigstens eines zweiten Lochs (126), welches durch die Abdeckung (114) hindurch gebildet ist, außerhalb des zweiten Hohlraums (112) mündet, wobei eine Höhe $H_A$ des ersten Kanals (116) im Bereich seines zweiten Endes (117B) kleiner ist als eine Höhe $H_B$ des zweiten Kanals (122) im Bereich seines zweiten Endes (123B),
- Aufbringen wenigstens einer ersten Abschlussschicht (128) mit einer Dicke $E_1$ größer als die Höhe $H_A$ und kleiner als die Höhe $H_B$, wodurch der erste Kanal (116) geschlossen wird, ohne den zweiten Kanal (122) zu schließen, und dann
- Schließen des zweiten Kanals (122),

wobei die Atmosphären in dem ersten und dem zweiten Hohlraum (110, 112) hinsichtlich des Drucks und/oder der Art des Gases unterschiedlich sind.

12. Verfahren nach Anspruch 11, wobei die erste Abschlussschicht (128) derart aufgebracht wird, dass wenigstens ein erster Bereich (132) der ersten Abschlussschicht (128) das zweite Ende (117B) des ersten Kanals (116) blockiert, und dann der zweite Kanal (122) geschlossen wird durch:

- ein Aufbringen wenigstens einer zweiten Abschlussschicht (136) mit einer Dicke $E_2$ derart, dass $H_B < (E_1 + E_2)$, und dass wenigstens ein zweiter Bereich (134) der ersten Abschlussschicht (128) und ein Bereich (142) der zweiten Abschlussschicht (136) das zweite Ende (123B) des zweiten Kanals (122) verschließt, oder
- ein Aufbringen wenigstens eines Bereichs (152) von Lötmaterial mit einer Dicke $E_2$ derart, dass $H_B < (E_1 + E_2)$ auf den zweiten Bereich (134) der ersten Abschlussschicht (128), und dann ein Löten des Bereichs (152) von Lötmaterial, oder
- die Herstellung wenigstens eines Bereichs (154, 156) einer Blockierschicht, die das zweite Loch (126) auf der Abdeckung (114) blockiert.

13. Verfahren nach einem der Ansprüche 11 oder 12, wobei die Herstellung der Abdeckung (114) und des ersten (116) und des zweiten (122) Kanals wenigstens die Durchführung der folgenden Schritte umfasst:

- Herstellen des ersten (116) und des zweiten (122) Kanals im Bereich einer Fläche eines zweiten Substrats, das dazu ausgelegt ist, mit dem ersten Substrat (102) verbunden zu werden;
- Herstellen des ersten (110) und des zweiten (112) Hohlraums im Bereich der Fläche des zweiten Substrats;
- Verbinden der Fläche des zweiten Substrats mit dem ersten Substrat (102);
- Herstellen des ersten (120) und des zweiten (126) Lochs durch das zweite Substrat hindurch,

wobei der erste Kanal (116) wenigstens eine Seitenwand (118) des ersten Hohlraums (110) durchsetzt, und/oder wobei der zweite Kanal (122) wenigstens eine Seitenwand (124) des zweiten Hohlraums (112) durchsetzt.

14. Verfahren nach einem der Ansprüche 11 oder 12, wobei die Herstellung der Abdeckung (114) und des ersten (116) und des zweiten (122) Kanals wenigstens die Durchführung der folgenden Schritte umfasst:

- Herstellen des ersten (110) und des zweiten (112) Hohlraums im Bereich einer Fläche eines zweiten Substrats, das dazu ausgelegt ist, mit dem ersten Substrat (102) verbunden zu werden;
- Herstellen einer Verklebungsgrenzfläche auf der Fläche des zweiten Substrats und/oder auf einer Fläche (108) des ersten Substrats (102), mit der das zweite Substrat verbunden werden soll, wobei der erste (116) und der zweite (122) Kanal wenigstens teilweise in der Verklebungsgrenzfläche gebildet werden;
- Verbinden der Fläche des zweiten Substrats mit dem ersten Substrat (102) mittels der Verklebungsgrenzfläche;
- Herstellen des ersten (120) und des zweiten (126) Lochs durch das zweite Substrat hindurch.

15. Verfahren nach einem der Ansprüche 11 oder 12, wobei die Herstellung der Abdeckung (114) und des ersten (116) und des zweiten (122) Kanals wenigstens die Durchführung der folgenden Schritte umfasst:

- Herstellen des ersten (116) und des zweiten (122) Kanals in dem ersten Substrat (102);
- Herstellen eines ersten und eines zweiten Bereichs aus Opfermaterial auf dem ersten Substrat (102), deren Volumina jenen des ersten (110) und des zweiten (112) Hohlraums entsprechen, und derart, dass der erste Bereich aus Opfermaterial wenigstens einen Teil des ersten Kanals (116) bedeckt, und dass der zweite Bereich aus Opfermaterial wenigstens einen Teil des zweiten Kanals (122) bedeckt;
- Aufbringen wenigstens einer dünnen Schicht auf dem ersten und dem zweiten Bereich aus Opfermaterial;
- Herstellen des ersten (120) und des zweiten (126) Lochs durch die dünne Schicht hindurch;
- Ätzen des ersten und des zweiten Bereichs aus Opfermaterial durch das erste (120) und das zweite (126) Loch hindurch.

16. Verfahren nach einem der Ansprüche 11 oder 12, wobei die Herstellung der Abdeckung (114) und des ersten (116) und des zweiten (122) Kanals wenigstens die Durchführung der folgenden Schritte umfasst:

- Herstellen eines ersten und eines zweiten Bereichs aus Opfermaterial auf dem ersten Substrat (102), deren Volumina jenen des ersten (110) und des zweiten (112) Hohlraums entsprechen;
- Aufbringen wenigstens einer ersten dünnen Schicht (158) auf dem ersten und dem zweiten Bereich aus Opfermaterial;
- Herstellen eines dritten (162) und eines vierten (164) Lochs durch die erste dünne Schicht (158) hindurch, wobei das dritte Loch (162) im Bereich einer Stelle des ersten Endes (117A) des ersten Kanals (116) gebildet wird, der hergestellt werden soll, und das vierte Loch (164) im Bereich einer Stelle des ersten Endes (123A) des zweiten Kanals (122) gebildet wird, der hergestellt werden soll;
- Herstellen, auf der ersten dünnen Schicht (158) wenigstens eines dritten Bereichs aus Opfermaterial, dessen Dicke gleich der Höhe $H_A$ ist, wenigstens im Bereich einer Stelle des ersten Kanals (116), und wenigstens eines vierten Bereichs aus Opfermaterial, dessen Dicke gleich der Höhe $H_B$ ist, wenigstens im Bereich einer Stelle des zweiten Kanals (122);
- Aufbringen wenigstens einer zweiten dünnen Schicht (160) auf der ersten dünnen Schicht (158), die den dritten und den vierten Bereich aus Opfermaterial bedeckt;
- Herstellen des ersten (120) und des zweiten (126) Lochs durch die zweite dünne Schicht (160) hindurch;
- Ätzen des ersten, des zweiten, des dritten und des vierten Bereichs aus Opfermaterial durch wenigstens das erste (120) und das zweite (126) Loch hindurch.

**Claims**

1. A packaging structure (100) including:

   - at least one cover (114) secured to at least one first substrate (102) and forming at least first (110) and second (112) distinct cavities between the cover (114) and the first substrate (102),
   - at least first (116) and second (122) channels made in the first substrate (102) and/or in the cover (114) and/or between the first substrate (102) and the cover (114), such that the first channel (116) includes a first end (117A) leading into the first cavity (110) and a second end (117B) leading off the first cavity (110) via at least one first hole (120) made through the cover (114), and in that the second channel (122) includes a first end (123A) leading into the second cavity (112) and a second end (123B) leading off the second cavity (112) via at least one second hole (126) made through the cover (114),

   wherein a height $H_A$ of the first channel (116) at its second end (117B) is lower than a height $H_B$ of the second channel (122) at its second end (123B), and wherein at least one first closing layer (128) with a thickness $E_1$ higher than the height $H_A$ and lower than the height $H_B$ closes the first channel (116) without closing the second channel (122), and wherein the second channel (122) is closed, the atmospheres in the first and second cavities (110, 112) being different in terms of pressure and/or nature of gases.

2. The packaging structure (100) according to claim 1, wherein the difference between the heights $H_A$ and $H_B$ is such that it is possible to close the first channel (116) via depositing the first closing layer (128) at the second ends (117B, 123B) of the first and second channels (116, 122) without closing the second channel (122).

3. The packaging structure (100) according to one of previous claims, wherein the second end (117B) of the first channel (116) is plugged by at least one first portion (132) of the first closing layer (128) with the thickness $E_1$ higher than the height $H_A$ and lower than the height $H_B$, and wherein the second end (123B) of the second channel (122) is plugged by at least:

- one second portion (134) of the first closing layer (128) and a portion (142) of a second closing layer (136) with a thickness $E_2$ such that $H_B < (E_1 + E_2)$, or
- the second portion (134) of the first closing layer (128) and a portion (142) of a material soldered to the second portion (134) of the first closing layer (128) and with a thickness $E_2$ such that $H_B < (E_1 + E_2)$, or
- the second portion (134) of the first closing layer (128) and a portion (154, 156) of a plugging layer plugging the second hole (126) on the cover (114).

4. The packaging structure (100) according to one of previous claims, wherein at least one first micro-device (104) is provided in the first cavity (110) and/or wherein at least one second micro-device (106) is arranged in the second cavity (112).

5. The packaging structure (100) according to claims 3 and 4, wherein:

 - when the first micro-device (104) is provided in the first cavity (110), the first closing layer (128) includes at least one electrically conductive material, the packaging structure (100) including at least one first electrical connection element (144) connected to the first micro-device (104) and to the first portion (132) of the first closing layer (128), and at least one first electrical contact (148) provided at least partly in the first hole (120) and connected to the first portion (132) of the first closing layer (128), and/or
 - when the second micro-device (106) is provided in the second cavity (112), the materials (134, 142) plugging the second end (123B) of the second channel (122) are electrically conductive, the packaging structure (100) including at least one second electrical connection element (146) connected to the second micro-device (106) and to the second portion (134) of the first closing layer (128), and at least one second electrical contact (146) provided at least partly in the second hole (126) and connected to the portion (142) of the second closing layer (136) or to the portion (152) of the material soldered to the second portion (134) of the first closing layer (128).

6. The packaging structure (100) according to one of previous claims, wherein the first channel (116) passes through at least one side wall (118) of the first cavity (110) and/or wherein the second channel (122) passes at least through a side wall (124) of the second cavity (112).

7. The packaging structure (100) according to one of previous claims, wherein the cover (114) includes at least one substrate called a second substrate secured to the first substrate (102) and such that the first (110) and second (112) cavities are formed at least partly in the second substrate.

8. The packaging structure (100) according to claim 7, wherein the second substrate is secured to the first substrate (102) via a bonding interface provided between the first substrate (102) and the second substrate and such that the first (116) and second (122) channels are formed at least partly in the bonding interface.

9. The packaging structure (100) according to one of claims 1 to 6, wherein the cover (114) includes at least one thin layer provided on the first substrate (102), and wherein the first (116) and second (122) channels are formed at least in the first substrate (102).

10. The packaging structure (100) according to one of claims 1 to 5, wherein the cover (114) includes at least two thin layers (158, 160) superimposed above each other and provided on the first substrate (102), and wherein the first (116) and second (122) channels are formed at least by spaces between both thin layers (158, 160).

11. A method for making a packaging structure (100), including at least the following steps:

 - making at least one cover (114) secured to at least one first substrate (102) forming at least first (110) and second (112) distinct cavities between the cover (114) and the first substrate (102),
 - making at least first (116) and second (122) channels in the first substrate (102) and/or in the cover (114) and/or between the first substrate (102) and the cover (114), such that the first channel (116) includes a first end (117A) leading into the first cavity (110) and a second end (117B) leading off the first cavity (110) via at least one first hole (120) made through the cover (114), and in that the second channel (122) includes a first end (123A) leading into the second cavity (112) and a second end (123B) leading off the second cavity (112) via at least one second hole (126) formed through the cover (114), wherein a height $H_A$ of the first channel (116) at its second end (117B) is lower than a height $H_B$ of the second channel (122) at its second end (123B),
 - depositing at least one first closing layer (128) with a thickness $E_1$ higher than the height $H_A$ and lower than the height $H_B$, which closes the first channel (116) without closing the second channel (122), then
- closing of the second channel (122),

the atmospheres in the first and second cavities (110, 112) being different in terms of pressure and/or nature of gases.

12. The method according to claim 11, wherein the first closing layer (128) is deposited such that at least one first portion (132) of the first closing layer (128) plugs the second end (117B) of the first channel (116), then the second channel (122) is closed by :

- depositing at least one second closing layer (136) with a thickness $E_2$ such that $H_B < (E_1 + E_2)$ and that at least one second portion (134) of the first closing layer (128) and a portion (142) of the second closing layer (136) plugs the second end (123B) of the second channel (122), or
- depositing at least one portion (152) of soldering material with a thickness $E_2$ such that $H_B < (E_1 + E_2)$ onto the second portion (134) of the first closing layer (128), and then soldering the portion (152) of soldering material, or
- making at least one portion (154, 156) of plugging layer plugging the second hole (126) on the cover (114).

13. The method according to one of claims 11 or 12, wherein making the cover (114) and the first (116) and second (122) channels includes at least the implementation of the following steps of:

- making first (116) and second (122) channels at a face of a second substrate intended to be secured to the first substrate (102);
- making first (110) and second (112) cavities at said face of the second substrate;
- securing said face of the second substrate to the first substrate (102);
- making first (120) and second (126) holes through the second substrate,

wherein the first channel (116) passes at least through a side wall (118) of the first cavity (110) and/or wherein the second channel (122) passes at least through a side wall (124) of the second cavity (112).

14. The method according to one of claims 11 or 12, wherein making the cover (114) and the first (116) and second (122) channels includes at least the implementation of the following steps of:

- making first (110) and second (112) cavities at one face of a second substrate intended to be secured to the first substrate (102);
- making a bonding interface on said face of the second substrate and/or a face (108) of the first substrate (102) to which the second substrate is intended to be secured, the first (116) and second (122) channels being formed at least partly in the bonding interface;
- securing said face of the second substrate to the first substrate (102) via the bonding interface;
- making the first (120) and second (126) holes through the second substrate.

15. The method according to one of claims 11 or 12, wherein making the cover (114) and the first (116) and second (122) channels includes at least the implementation of the following steps of:

- making first (116) and second (122) channels in the first substrate (102);
- making first and second portions of sacrificial material on the first substrate (102), volumes of which correspond to those of the first (110) and second (112) cavities and such that the first portion of sacrificial material covers at least one part of the first channel (116) and in that the second portion of sacrificial material covers at least one part of the second channel (122);
- depositing at least one thin layer onto the first and second portions of sacrificial material;
- making first (120) and second (126) holes through the thin layer;
- etching the first and second portions of sacrificial material through the first (120) and second (126) holes.

16. The method according to one of claims 11 or 12, wherein making the cover (114) and the first (116) and second (122) channels includes at least the implementation of the following steps of:

- making first and second portions of sacrificial material on the first substrate (102), volumes of which correspond to those of the first (110) and second (112) cavities;
- depositing at least one first thin layer (158) onto the first and second portions of sacrificial material;
- making third (162) and fourth (164) holes through the first thin layer (158), the third hole (162) being formed at a location of the first end (117A) of the first channel (116) intended to be made and the fourth hole (164) being formed at a location of the first end (123A) of the second channel (122) intended to be made;
- making, on the first thin layer (158), at least one third portion of sacrificial material a thickness of which is equal to the height $H_A$, at least at a location of the first channel (116), and at least one fourth portion of sacrificial material a thickness of which is equal to the height $H_B$, at least at a location of the second channel (122);
- depositing at least one second thin layer (160) onto the first thin layer (158), covering the third and fourth portions of sacrificial material;
- making first (120) and second (126) holes through the second thin layer (160);
- etching first, second, third and fourth portions of sacrificial material through at least the first (120) and second (126) holes.

Fig. 1A

Fig. 1B

Fig. 2

Fig. 3

EP 2 952 471 B1

**Fig. 4**

**Fig. 5**

**Fig. 6**

24

**Fig. 7A**

**Fig. 7B**

**Fig. 8**

**Fig. 9**

**Fig. 10A**

**Fig. 10B**

**Fig. 10C**

## RÉFÉRENCES CITÉES DANS LA DESCRIPTION

**Documents brevets cités dans la description**

- US 8590376 B2
- US 8350346 B1
- US 8035209 B2
- US 20140008738 A1
- US 20120326248 A1
- US 20140038364 A1